(19) **Europäisches Patentamt / European Patent Office / Office européen des brevets**

(11) **EP 3 451 204 B1**

(12) **EUROPEAN PATENT SPECIFICATION**

(45) Date of publication and mention of the grant of the patent:
**19.10.2022 Bulletin 2022/42**

(21) Application number: **17855357.4**

(22) Date of filing: **10.07.2017**

(51) International Patent Classification (IPC):
*F22B 1/16* (2006.01)    *F22B 37/20* (2006.01)
*F22B 35/18* (2006.01)    *F22B 35/00* (2006.01)

(52) Cooperative Patent Classification (CPC):
**F22B 37/206; F22B 1/16; F22B 35/004; F22B 35/18; G06F 30/00**

(86) International application number:
**PCT/JP2017/025132**

(87) International publication number:
**WO 2018/061398 (05.04.2018 Gazette 2018/14)**

(54) **SELF-EXCITED VIBRATION EVALUATION METHOD**

VERFAHREN ZUR BEURTEILUNG VON SELBSTERREGTER SCHWINGUNG

PROCÉDÉ D'ÉVALUATION DE VIBRATION AUTO-EXCITÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2016 JP 2016193085**

(43) Date of publication of application:
**06.03.2019 Bulletin 2019/10**

(73) Proprietor: **Mitsubishi Heavy Industries, Ltd.**
**Tokyo 108-8215 (JP)**

(72) Inventors:
- **NISHIDA, Shingo**
  **Tokyo 108-8215 (JP)**
- **IWASAKI, Makoto**
  **Tokyo 108-8215 (JP)**
- **HIROTA, Kazuo**
  **Tokyo 108-8215 (JP)**
- **KAWAKAMI, Ryoichi**
  **Tokyo 108-8215 (JP)**

(74) Representative: **Cabinet Beau de Loménie**
**158, rue de l'Université**
**75340 Paris Cedex 07 (FR)**

(56) References cited:
**JP-A- 2014 109 906    JP-A- 2014 134 957**

- **SHAHAB KHUSHNOOD ET AL: "A review of heat exchanger tube bundle vibrations in two-phase cross-flow", NUCLEAR ENGINEERING AND DESIGN, vol. 230, no. 1-3, 1 May 2004 (2004-05-01), pages 233-251, XP055593506, NL ISSN: 0029-5493, DOI: 10.1016/j.nucengdes.2003.11.024**
- **XIN XIN ET AL: "Optimal control design of self-excited vibration systems", SYSTEMS, MAN, AND CYBERNETICS, 1999. IEEE SMC '99 CONFERENCE PROCEEDIN GS. 1999 IEEE INTERNATIONAL CONFERENCE ON TOKYO, JAPAN 12-15 OCT. 1999, PISCATAWAY, NJ, USA,IEEE, US, vol. 5, 12 October 1999 (1999-10-12), pages 110-115, XP010362825, DOI: 10.1109/ICSMC.1999.815530 ISBN: 978-0-7803-5731-0**
- **HIROKI TANAKA: "Study on Fluid-elastic Vibration of Tube Bundle (Multi-rows of Cylinders", Transactions of the Japan Society of Mechanical Engineers, vol. 46, no. 404 April 1980 (1980-04), pages 600-609, XP009511552, ISSN: 0387-5008 [retrieved on 2017-08-30]**
- **TOSHIHIKO HORIUCHI: "Impact Vibration Analysis of Group of Hexagonal Bars Immersed in Liquid", Transactions of the Japan Society of Mechanical Engineers Series C, vol. 60, no. 576 August 1994 (1994-08), pages 2691-2698, XP009511563, ISSN: 0387-5024 [retrieved on 2017-08-30]**

**Description**

TECHNICAL FIELD

The present disclosure relates to a field of vibration analysis of a structure, especially to a self-excited vibration evaluation method for evaluating self-excited vibration that occurs in a tube bundle disposed in a fluid.

BACKGROUND ART

A known fluid dynamics analysis technique performs analysis on a vibration phenomenon that occurs in a tube bundle disposed in a fluid, utilizing an electronic calculation device such as a computer. Such a fluid dynamics technique is applied to analyze behavior of a tube bundle that vibrates in response to an excitation force of a fluid serving as a heat exchange medium, such as a bundle of heat-transfer tubes forming a steam generator like a boiler and a nuclear power plant device, for instance.

For instance, in a steam generator used in a pressurized-water reactor (PWR), heat-transfer tubes carrying primary cooling water supplied from a reactor are arranged in parallel so as to form a tube bundle, and secondary cooling water flows through the outer surface of the heat-transfer surface of the tube bundle to exchange heat. In such a steam generator, the heat exchange efficiency can be improved by increasing the flow velocity of the secondary cooling water. However, if the flow velocity exceeds a critical flow velocity, self-excited vibration (hydroelastic vibration) may occur. The self-excited vibration is unstable vibration where the motion of the tube bundle and the fluid flow affect each other, and may cause damage to the tube bundle.

As a technique for evaluating occurrence of such self-excited vibration, for instance, Patent Document 1 discloses predicting the critical flow velocity through numerical simulation using computation fluid dynamics (CFD) capable of reducing the time and costs while using a large number of parameters. Other vibration evaluation models are known from Shahab Khushnood et al "A review of heat exchanger tuber bundle vibrations in two-phase cross-flow", Xin Xin et al "Optimal control design of self-excited vibration systems", JP 2014 109906 and JP 2014 134957.

Citation List

Patent Literature

Patent Document 1: JP2015-026259A

SUMMARY

Problems to be Solved

In recent years, it has been pointed out that a self-excited vibration phenomenon like hydroelastic vibration may occur along the flow direction of a fluid in a tube bundle having a U bend portion such as a U-shaped tube. The U-shaped tube is supported by an anti-vibration bar (vibration suppressing member) disposed in the gap between the tubes, and such vibration phenomenon along the flow direction is suppressed by a friction force between the tubes and the anti-vibration bar. In a typical technique as in Patent Document 1, although linear damping (e.g., structure damping, bi-phase damping) is taken into account, it is assumed as a premise that the pressing force is zero at all support points where respective U-shape tubes and the anti-vibration bar make contact, and the friction force for suppressing the vibration phenomenon along the flow direction is not taken into account. Thus, it is not possible to evaluate self-excited vibration along the flow direction appropriately.

At least one embodiment of the present invention was made in view of the above issue, and an object is to provide a self-excited vibration evaluation method capable of evaluating self-excited vibration appropriately by taking into account friction damping between a tube bundle and a support member.

Solution to the Problems

(1) According to at least one embodiment of the present invention, a self-excited vibration evaluation method for evaluating self-excited vibration of a tube bundle arranged in a fluid so as to be supported by a support member includes the steps of claim 1.

In the above method (1), the time history response analysis of simulating a change in the vibration amplitude of the tube bundle is executed while changing the negative damping ratio corresponding to the excitation force of the fluid, and the critical flow velocity of the fluid is calculated on the basis of the minimum negative damping ratio at which a change in the vibration amplitude diverges. Herein, the minimum negative damping ratio at which the change of the vibration amplitude of the tube bundle diverges corresponds to the maximum negative damping ratio that the vibration system expressing the tube bundle can tolerate without causing self-excited vibration, which is the maximum friction damping ratio that can be applied to suppress self-excited vibration. As a result, according to the above method (1), it is possible to evaluate self-excited vibration appropriately taking account of the friction damping effect applied to the tube bundle, when the tube bundle including a plurality of tubes arranged in a fluid is supported by a friction force from a support member against the excitation force of the fluid.

(2) In the invention, the time history response analysis includes calculation which includes time-series simulation of vibration amplitude which occurs when an excitation force corresponding to the negative damping ratio is applied as an external force term to a vibration analysis model of the tube bundle, and the vibration analysis model determines a magnitude of a friction force between the tube bundle and the support member, by assuming a distribution of a contact load acting between the tube bundle and the support member.

According to the above method (2), after building a vibration analysis model which specifies the magnitude of the friction force between the tube bundle and the support member, the vibration amplitude which occurs when the excitation force corresponding to the negative damping ratio is applied to the vibration analysis model is simulated in a time-series manner. Thus, according to the above method (2), it is possible to obtain the minimum negative damping ratio at which the change of the vibration amplitude of the tube bundle diverges, taking account of the effect that the friction force between the tube bundle and the support member attenuates the excitation force corresponding to the negative damping ratio.

(3) In some embodiments, in the above method (1) or (2), the time history response analysis includes: calculating an effective damping ratio of the tube bundle on the basis of an offset relationship between the negative damping ratio and a first damping ratio corresponding to an energy dissipation amount of the self-excited vibration dissipated in accordance with a friction force between the tube bundle and the support member; and performing time-series estimation of the vibration amplitude of the tube bundle on the basis of the calculated effective damping ratio.

According to the above method (3), the effective damping ratio of the entire tube bundle is calculated, focusing on the fact that there is an offset relationship between the negative damping ratio and the first damping ratio corresponding to the energy dissipation amount of self-excited vibration that is dissipated in accordance with the friction force between the tube bundle and the support member. Further, in the above method (3), on the basis of the effective damping ratio, the vibration amplitude of the tube bundle is estimated in a time-series manner. Thus, according to the above method (3), it is possible to evaluate the effect of dissipation of energy of self-excited vibration in accordance with the friction force between the tube bundle and the support member, as an offset effect between the negative damping ratio and the first damping ratio corresponding to the energy dissipation amount. Then, according to the above method (3), it is possible to obtain the minimum negative damping ratio at which the change of the vibration amplitude of the tube bundle diverges, taking into account the above offset effect.

(4) In some embodiments, in the above method (3), the time history response analysis includes: determining that the vibration amplitude diverges at the time when the negative damping ratio becomes equal to the first damping ratio as the vibration amplitude of the tube bundle changes.

According to the above method (4), the vibration characteristics of the tube bundle are evaluated on the basis of an offset effect between the negative damping ratio corresponding to the excitation force of the fluid and the first damping ratio corresponding to the energy dissipation amount of self-excited vibration, thereby obtaining the minimum negative damping ratio at which the change of the vibration amplitude of the tube bundle diverges, taking account of the offset effect. Then, in the above method (4), it is determined that the vibration amplitude of the tube bundle diverges at the time when the negative damping ratio becomes equal to the first damping ratio, in accordance with a change in the vibration amplitude of the tube bundle. As a result, according to the above method (4), it is possible to estimate the negative damping ratio corresponding to the excitation force of the fluid at the time of the critical flow velocity as the negative damping ratio that balances with the first damping ratio corresponding to the energy dissipation amount of self-excited vibration.

(5) According to an example, a self-excited vibration evaluation method for evaluating self-excited vibration of a tube bundle arranged in a fluid so as to be supported by a support member includes: an expected flow velocity acquisition step of obtaining an expected flow velocity of the fluid; a negative damping ratio calculation step of, provided that the expected flow velocity is a critical flow velocity, calculating a negative damping ratio corresponding to the expected flow velocity, on the basis of a correlation between the critical flow velocity and a negative damping ratio of the entire tube bundle; and an evaluation step of evaluating the self-excited vibration of the tube bundle on the basis of whether the vibration amplitude of the tube bundle diverges when calculation including simulation of the self-excited vibration of the tube bundle is executed by inputting the negative damping ratio.

In the above method (5), the obtained expected flow velocity is assumed to be the provisional critical flow velocity, and at the time of computation of simulating the self-excited vibration of the tube bundle is executed by inputting the negative damping ratio corresponding to the assumed provisional critical flow velocity, it is determined whether self-excited vibration occurs on the basis of whether the vibration amplitude of the tube bundle occurs. In other words, in the above method (5), it is checked if the provisional critical flow velocity exceeds the actual critical flow velocity, on the basis of whether vibration amplitude of the tube bundle diverges, when calculation of simulating self-excited vibration of the tube bundle is executed on the basis of the provisional critical flow velocity. Thus, according to the above method (5), through the simulation computation that simulates self-excited vibration of the tube bundle, it is possible to accurately predict whether self-excited vibration of the tube bundle actually occurs when the fluid flows at the flow velocity assumed to be the provisional critical flow velocity.

(6) In some examples, in the above method (5), the expected flow velocity acquisition step includes: an effective flow velocity calculation step of calculating an effective flow velocity of the fluid on the basis of a distribution, along a length direction of each of tubes included in the tube bundle, of at least one of a dynamic pressure of the fluid applied to each tube, a density of each tube, or an amplitude of each tube. The negative damping ratio calculation step includes calculating the negative damping ratio, provided that the effective flow velocity is the expected flow velocity.

According to the above method (6), the effective flow velocity of the fluid is calculated on the basis of a distribution, along the length direction, of the above dynamic pressure of the fluid applied to each tube of the tube bundle, the density of each tube, or the vibration amplitude of each tube, if the dynamic pressure, the density, or the vibration amplitude varies along the length direction. Then, in the above method (6), the negative damping ratio is calculated assuming that the effective flow velocity is the provisional critical flow velocity. Thus, according to the above method (6), even if the dynamic pressure of the fluid applied to each tube of the tube bundle, the density of each tube, or the vibration amplitude of each tube varies along the length direction of each tube, it is possible to obtain a single flow velocity value for calculating the negative damping ratio, taking into account a difference in the flow velocity by the location in the tube.

(7) In some embodiments, in the above methods (1) to (6), the tube bundle includes at least one tube row formed by a plurality of U-shaped tubes extending within the same plane and sharing a curvature center with one another, the U-shaped tubes including bend portions having different curvature radii from one another, the support member includes at least one pair of anti-vibration bars disposed on both sides of the tube row so as to extend along the plane across the tube row, and the method includes determining stability of hydroelastic vibration in a direction along the plane of the tube bundle supported by a friction force between the anti-vibration bars and the tube bundle against an excitation force of the fluid flowing through the tube bundle.

In a general heat exchanger, a tube bundle may include a plurality of U-shaped tubes each having a U-shaped bend portion, and an anti-vibration bar may be interposed between bend portions of adjacent U-shaped tubes in the out-of-plane direction which is a direction orthogonal to the plane including the bend portions. In this case, the anti-vibration bar interposed between adjacent tube rows restricts movement of the respective U-shaped tubes (bend portions) in the out-of-plane direction, and thus the entire tube bundle integrally vibrates in response to an excitation force that acts in the out-of-plane direction. However, a series of U-shaped tubes arranged in the in-plane direction, which is a direction along the plane including the bend portions, are restricted only by the friction force from the anti-vibration bars on the opposite sides. Thus, in the methods (1) to (6), the direction of vibration of each tube is substantially equal to the in-plane direction, and the contact load that each tube receives from collision with adjacent anti-vibration bars is mainly a friction force in the in-plane direction.

Thus, in the above method (7), it is possible to perform stability determination of hydroelastic vibration appropriately in the in-plane direction of the tube bundle assuming that the friction force received from the anti-vibration bar adjacent to the tube row is acting against the excitation force applied to each U-shaped tube, within the plane (in-plane direction) in which tube rows including U-shaped portions with bend portions extends.

(8) In some examples, in the above method (1) or (7), the tube bundle comprises a bundle of heat-transfer tubes of a steam generator of a PWR nuclear power plant.

According to the above method (8), when a heat exchanger such as a steam generator is provided for a nuclear power plant facility including a pressurized-water reactor, it is possible to evaluate in advance the maximum limit flow velocity that tube bundle disposed in the fluid for heat exchange can tolerate without causing self-excited vibration. As a result, it is possible to design the structure of the heat-transfer tube bundle taking account of the anti-vibration performance.

Advantageous Effects

According to at least one embodiment of the present invention, it is possible to provide a self-excited vibration evaluation method capable of evaluating self-excited vibration appropriately by taking account of the friction damping between the tube bundle and the support member.

BRIEF DESCRIPTION OF DRAWINGS

FIG. 1 is a perspective view of a U bend portion of a heat-transfer tube bundle according to an example.

FIG. 2 is a view of an example of a support structure including an anti-vibration bar, as seen in the in-plane direction.

FIG. 3 is a view of an example of a support structure including an anti-vibration bar, as seen in the out-of-plane direction.

FIG. 4A is a diagram illustrating a computer device for executing a self-excited vibration evaluation method according to an example.

FIG. 4B is a diagram illustrating an internal configuration of a computation part of a computer device depicted in FIG. 4.

FIG. 5 is a curve graph showing a relationship between the negative damping ratio and the vibration amplitude obtained by time history response analysis.

FIG. 6 is a flowchart of an execution process of a self-excited vibration evaluation method according to an embodiment.

FIG. 7 is a diagram illustrating a computer device for executing a self-excited vibration evaluation method according to yet another embodiment.

FIG. 8 is a flowchart of an execution process of a self-excited vibration evaluation method according to a yet another embodiment.

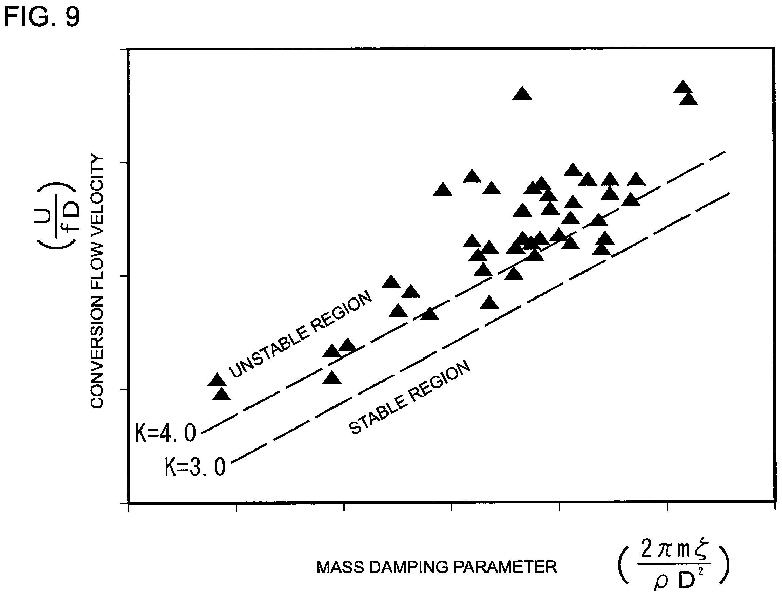

FIG. 9 is a diagram illustrating a stability determination map for determining occurrence of self-excited vibration.

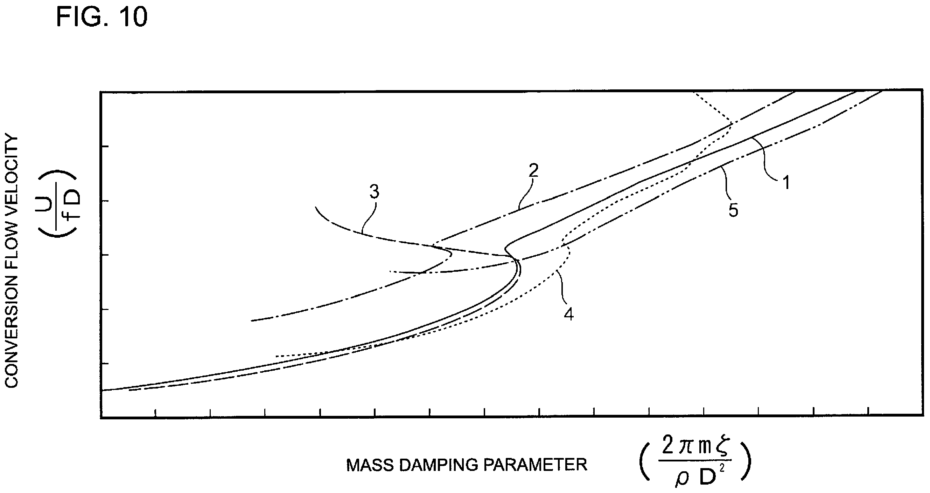

FIG. 10 is a diagram showing a correlation between the conversion flow velocity and the damping ratio at stability limit.

## DETAILED DESCRIPTION

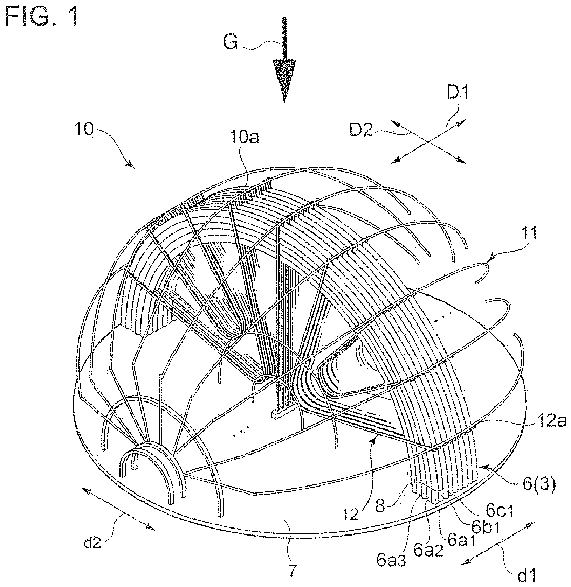

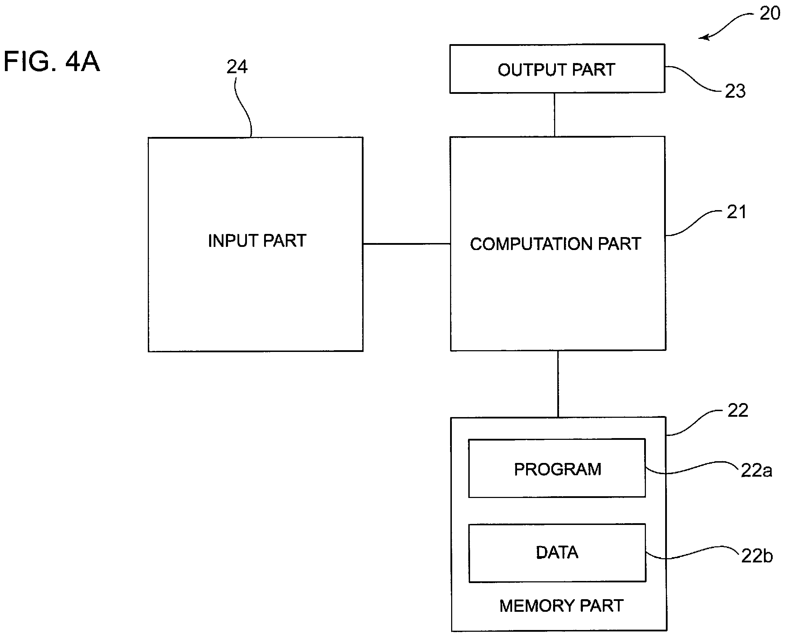

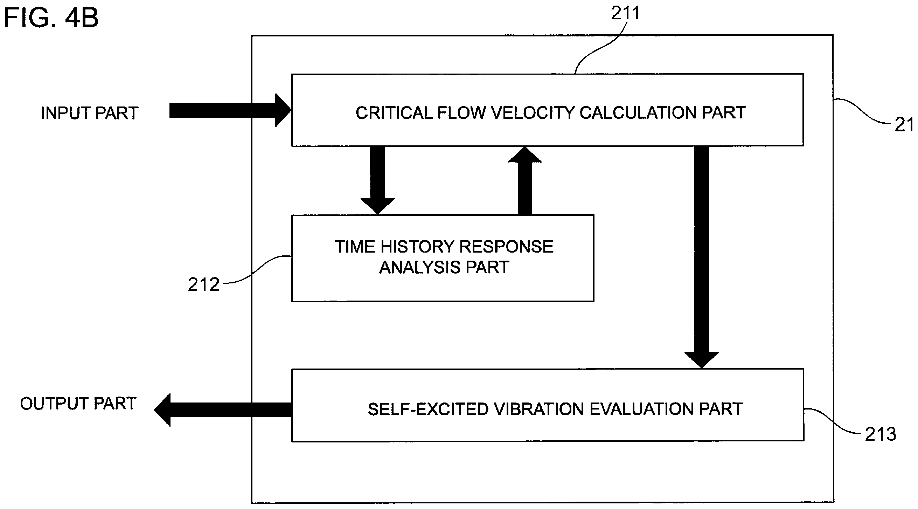

A self-excited vibration evaluation method according to some embodiments of the present invention will now be described in detail with reference to the accompanying drawings. The self-excited vibration evaluation method according to some embodiments of the present invention can be applied to any tube bundle structure, as long as the tube structure includes a plurality of tubes disposed in a fluid and supported by a friction force generated between the tubes and a support member, against a hydrodynamic force. Hereinafter, the structure of a heat-transfer tube bundle shown in FIGs. 1 to 3 will be described as an example of tube bundle structure, which can be an application of a self-excited vibration evaluation method according to some embodiments of the present invention. Subsequently, the processes in the self-excited vibration evaluation method will be described with reference to FIGs. 4 to 8.

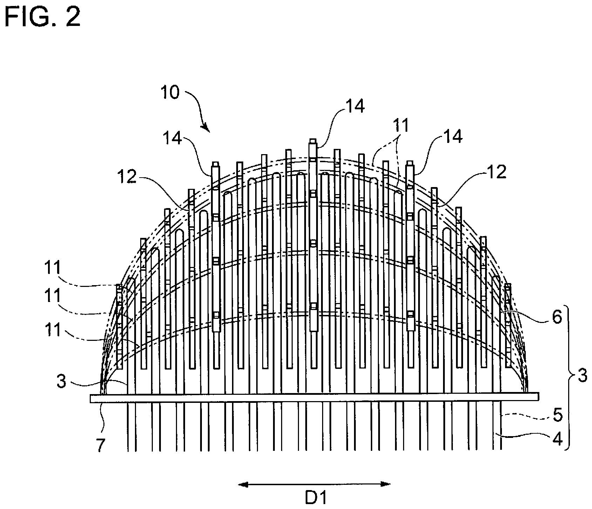

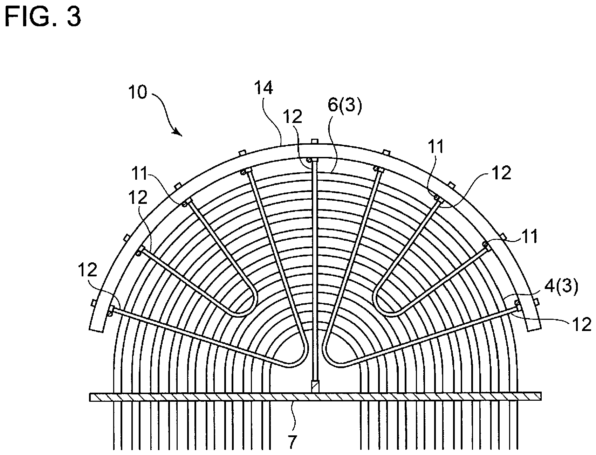

FIG. 1 is a perspective view of a U bend portion 10a of a heat-transfer tube bundle 10 according to an example. FIG. 2 is a side view of the heat-transfer tube bundle 10 as seen in the in-plane direction D2 in FIG. 1 (row direction d2 in FIG. 1), and FIG. 3 is a side view of the heat-transfer tube bundle 10 as seen in the out-of-plane direction D1 in FIG. 1 (row direction d1 in FIG. 1). In FIG. 1, a part of constituent components are omitted for clarity. The part of constituent elements omitted from FIG. 1 is shown in FIGs. 2 and 3, which illustrate side views of the heat-transfer tube bundle in FIG. 1.

In some examples, the heat-transfer tube bundle 10 includes a plurality of heat-transfer tubes 3, and a tube support plate 7 through which the plurality of heat-transfer tubes 3 are inserted, and configured to generate steam through heat exchange with a fluid flowing through the plurality of heat-transfer tubes 3. The plurality of heat-transfer tubes 3 each include a first span of straight tube portion 4 disposed on the inlet side of the fluid, a second span of straight tube portion 5 disposed on the outlet side of the fluid, and a bend portion 6 positioned between the first span of straight tube portion 4 and the second span of straight tube portion 5. The tube support plate 7 has a plurality of through holes formed thereon, and the first span of straight tube portion 4 and the second span of straight tube portion 5 are inserted through the through holes.

The heat-transfer tube bundle 10 includes the plurality of heat-transfer tubes 3 each having a U-shaped bend portion 6. The bend portions 6 of the plurality of heat-transfer tubes 3 form a U bend portion 10a. In the structure shown in FIG. 1, heat-transfer tubes 3 with a bend portion 6 whose curvature radius increases toward the outer side in the radial direction of the bend portion 6 (upper side in FIG. 1) are arranged along the same plane (along the in-plane direction D2) so as to share the same curvature center with one another (tube row 8 in FIG. 1). FIG. 3 is a diagram illustrating a plurality of tube rows 8 each including heat-transfer tubes 3 arranged along the in-plane direction D2, and the plurality of tube rows 8 are disposed next to one another in a direction orthogonal to the plane including the bend portions 6 (in the out-of-plane direction D1 in FIG. 1).

As shown in FIGs. 1 and 3, the curvature radius of the bend portion 6 of the heat-transfer tube 3 disposed on the radially outermost side in each of the plurality of tube rows 8 varies depending on the position in the out-of-plane direction D1 of each tube row 8. Accordingly, by changing the curvature radius of the bend portion 6 while stacking the plurality of tube rows 8 in the out-of-plane direction D1, a semi-sphere shaped U bend portion 10a is formed on the upper end portion of the heat-transfer tube bundle 10. As a result, as shown in FIG. 1, a plurality of bend portions $6a_1$, $6a_2$, $6a_3$, ..., having different curvature radii are arranged along the in-plane direction D2, and a plurality of bend portions $6a_1$, $6b_1$, $6c_1$ having the same curvature radii are arranged along the out-of-plane direction.

In the heat-transfer tube bundle 10, an anti-vibration bar 12 is interposed between bend portions 6 of adjacent heat-transfer tubes 3 in the out-of-plane direction orthogonal to the plane including the bend portion 6, and restricts movement of the plurality of heat-transfer tubes 3 (bend portions 6) in the out-of-plane direction D1. For instance, in FIG. 1, a plurality of anti-vibration bars 12 are inserted on both sides of each of the tube rows 8 arranged in the out-of-plane direction D1 along the in-plane direction D2, so as to restrict movement of the bend portions 6 the plurality of heat-transfer tubes 3 belonging to each tube row 8 in the out-of-plane direction D1.

As shown in FIG. 1, the first retaining bar 11 is an arc-shaped rod member attached along the outer periphery of the U bend portion 10a, that is, the outer periphery of the semi-sphere shape of the U bend portion 10a. The above described anti-vibration bar 12 extends inward in the radial direction of the semi-sphere shape of the U bend portion 10a from the first retaining bar 11. On the end portion 12a of the anti-vibration bar 12, the first retaining bar 11 is welded as shown in FIG. 1, and thereby end portions 12a of the plurality of anti-vibration bars 12 are connected. The first retaining bar 11 extends along the semispherical plane of the U bend portion 10a, orthogonal to the tube rows 8 including the plurality of heat-transfer tubes 3 stacked along the in-plane direction D2.

As shown in FIGs. 2 and 3, a plurality of first retaining bars 11 may be coupled via a second retaining bar (bridge) 14. The second retaining bar 14 is an arc-shaped and plate-shaped member disposed along the outer periphery of the U bend portion 10a, that is, the outer periphery of the semi-sphere shape of the U bend portion 10a. The second retaining bar 14 extends along the direction of extension of the bend portions 6 of heat-transfer tubes 3 at the U bend portion 10a. A plurality of second retaining bars 14 may be disposed so as to be aligned in the out-of-plane direction D1.

In the heat-transfer tube bundle 10, the anti-vibration bar 12 is interposed between bend portions 6 of adjacent heat-transfer tubes 3 in the out-of-plane direction to restrict movement of the plurality of heat-transfer tubes 3 (bend portions 6) in the out-of-plane direction D1, and thus the entire heat-transfer tube bundle 10 vibrates integrally in response to an excitation force that acts in the out-of-plane direction D1. However, a series of heat-transfer tubes 3 (tube rows 8 in FIG. 1) arranged in the in-plane direction D2 along the plane including the bend portions 6 are not connected to the anti-vibration bars 12 on the opposite sides, and are restricted only by the friction force from the anti-vibration bars 12 on the opposite sides. As a result, the direction of vibration of each heat-transfer tube 3 is substantially equal to the in-plane direction D2, and the contact load that each heat-transfer tube 3 receives from collision with adjacent anti-vibration bars 12 is mainly a friction force in the in-plane direction D2.

In an illustrative example, the heat-transfer tube bundle 10 described above with reference to FIGs. 1 to 3 may be configured as a heat-transfer tube bundle of a steam generator for performing heat exchange between the primary cooling water and the secondary cooling water, in a pressurized-water reactor (PWR) nuclear power plant facility. In this case, the secondary cooling water performs heat exchange with the primary cooling water flowing through the heat-transfer tubes 3, by flowing from directly above the U bend portion 10a toward directly below the U bend portion 10a, along the direction G orthogonal to the out-of-plane direction D1 and the in-plane direction D2 shown in FIG. 1. Thus, the flow of the secondary cooling water is an orthogonal flow that is orthogonal to the bend portions 6 of the heat-transfer tubes 3 at the uppermost portion of the U bend portion 10a. Accordingly, the self-excited vibration evaluation method according to some embodiments of the present invention may be performed to evaluate, in advance, the critical flow velocity that causes self-excited vibration in the heat-transfer tube bundle 10, as the critical flow velocity of the flow of the secondary cooling water for heat exchange flowing in a direction orthogonal to the U bend portion 10a in the above described steam generator.

As described above, provided that the heat-transfer tube bundle 10 is provided for a steam generator of a pressurized-water reactor, heat-transfer tubes 3 carrying primary cooling water supplied from the reactor are arranged in parallel so as to from a heat-transfer tube bundle 10, and the secondary cooling water flows through the outer surface of the heat-transfer surface of the heat-transfer tube bundle 10 to exchange heat. In such a steam generator, it is necessary to improve the heat exchange efficiency by increasing the flow velocity of the secondary cooling water. However, if the flow velocity exceeds a critical flow velocity, self-excited vibration may occur in the heat-transfer tube bundle 10. The self-excited vibration is unstable structural behavior where the motion of the heat-transfer tube bundle 10 and the fluid flow affect each other, causing the vibration amplitude to increase with time, which is a serious problem that may cause damage to the heat-transfer tube bundle 10.

Thus, to prevent self-excited vibration of the heat-transfer tube bundle in the above described steam generator, the plurality of heat-transfer tubes 3 supported by the tube support plate 7 at the lower end portion are supported by a plurality of anti-vibration bars 12 inserted at the U bend portion 10a of the upper portion. That is, at the U bend portion 10a of the steam generator, the tube rows 8 including the plurality of heat-transfer tubes 3 arranged along the same plane are supported by anti-vibration bars 12 inserted therebetween. In this case, the contact load applied between the anti-vibration bar 12 and the bend portions 6 of the heat-transfer tubes 3 acts as an anti-vibration force that attenuates the energy of self-excited vibration caused by the hydrodynamic force of the secondary cooling water. It is advantageous to evaluate in advance the critical flow velocity in accordance with the magnitude of the anti-vibration force from the given structure of the heat-transfer tube bundle 10.

In some examples described below, self-excited vibration is evaluated exclusively for the bend portions 6 of the respective heat-transfer tubes 3 forming the U bend portion 10a of the heat-transfer tube bundle 10. Thus, in some examples, the U bend portion 10a of the heat-transfer tube bundle 10 is simply referred to as the heat-transfer tube bundle 10, and the bend portions 6 of the respective heat-transfer tubes 3 are simply referred to as the heat-transfer tubes 6 or tubes 6.

Next, a self-excited vibration evaluation method according to some embodiments of the present invention and a computer device for performing the self-excited vibration evaluation method will now be described in detail with reference to FIGs. 4 to 6. FIG. 4A is a diagram illustrating the overall configuration a computer device 20 for executing a self-excited vibration evaluation method according to some embodiments. The computer device 20 includes a computation part 21, a memory part 22, an output part 23, and an input part 24. In an illustrative example, the computation part 21 may be configured as a computation circuit which executes the self-excited vibration evaluation method for evaluating self-excited vibration of the heat-transfer tube bundle 10 disposed in the fluid fl while being supported by the anti-vibration bars 12, by reading and executing a program 22a stored in the memory part 22. Further, in the present example, the data that the computation part 21 needs to read and write upon execution of the self-excited vibration evaluation method may be stored in the memory part 22 as data 22b.

Further, the output part 23 is an output device for presenting a part of the computation result by the computation part 21 and the data 22b stored in the memory part 22 to a user. In an illustrative example, the output part 23 may include, as an output unit, a screen presentation unit such as a display device. Further, the input part 24 is an input device for inputting external data indicating various types of information and parameters to the computation part 21 in response to operation by a user. In an illustrative example, the input part 24 may include, as an input unit, a keyboard and a mouse, for instance.

FIG. 4B is a diagram illustrating an internal configuration of the computation part 21 of the computer device 20 depicted in FIG. 4. With reference to FIG. 4B, the computation part 21 includes a critical flow velocity calculation part 211 for calculating the critical flow velocity Ucr described below, and a self-excited vibration evaluation part 213 for receiving the calculation result of the critical flow velocity Ucr from the critical flow velocity calculation part 211 and evaluating the self-excited vibration of the heat-transfer tube bundle 10. Further, the computation part 21 further includes a time history response analysis part 212 which is repeatedly called by the critical flow velocity calculation part 211 to perform the time history response analysis. In an example, the computation part 21 may be realized by a general-purpose processor. In this case, the critical flow velocity calculation part 211, the time history response analysis part 212, and the self-excited vibration evaluation part 213 may be realized as a program module which is to be generated in the computation part 21 as the computation part 21 reads in the program 22a from the memory part 22.

Generally, the heat-transfer tube bundle 10 is modelized as a multiple degree of freedom vibration system, and thus the heat-transfer tube bundle 10 has a plurality of eigen frequencies $f(i)$ $(1<i<I)$, and the vibration of the heat-transfer tube bundle 10 is expressed as a synthesis of a plurality of eigenmodes $\varphi(i)(1\leq i\leq I)$. Accordingly, calculation of the critical flow velocity Ucr by the critical flow velocity calculation part 211 is executed individually for each of the eigenmodes $\varphi(i)(1\leq i\leq I)$, and the critical flow velocity Ucr $(i)$ $(1<i<I)$ is calculated for each of the eigenmodes $\varphi(i)(1\leq i\leq I)$. In other words, evaluation of the self-excited vibration of the heat-transfer tube bundle 10 having a plurality of eigen frequencies $f(i)$ $(1\leq i\leq I)$ is performed individually for each of the plurality of eigenmodes $\varphi(i)(1\leq i\leq I)$.

The critical flow velocity calculation part 211 shown in FIG. 4B calculates the critical flow velocity Ucr $(i')$ corresponding to one eigenmode $(i')$ as described below. First, in addition to the value of the expected flow velocity of the fluid fl passing through the heat-transfer tube bundle 10, input parameters required to calculate the critical flow velocity Ucr $(i')$ is received from the input part 24. For instance, in addition to the expected flow velocity, the critical flow velocity calculation part 211 receives information that identifies the data defining the vibration analysis model of the heat-transfer tube bundle 10 from the input part 24, from among the data 22b in the memory part 22. Next, the minimum flow velocity at which the heat-transfer tube bundle 10 causes self-excited vibration corresponding to the eigenfrequency $f(i')$, when the flow velocity of the fluid fl applying an excitation force $F_{ex}$ to the heat-transfer tube bundle 10 disposed supported by the anti-vibration bar 12 is increased, is calculated as the critical flow velocity Ucr $(i')$.

At this time, in the calculation process of the above critical flow velocity Ucr $(i')$, the critical flow velocity calculation part 211 calls the time history response analysis part 212 repeatedly for each value of the negative damping ratio $\zeta^r_{n(i')}$, while changing the value of the negative damping ratio $\zeta^r_{n(i')}$. The time history response analysis part 212, upon receiving each value of the negative damping ratio $\zeta^r_{n(i')}$ as an input and being called by the critical flow velocity calculation part 211, executes the time history response analysis of simulating a change in the vibration amplitude of the heat-transfer tube bundle 10. That is, the time history response analysis is parametric study computation which calculates the vibration amplitude of the heat-transfer tube bundle 10 in a case where an excitation force $F_{ex}$ corresponding to the negative damping ratio $\zeta^l_{n(i')}$ is applied to the heat-transfer tube bundle 10, with the value of the negative damping

ratio $\zeta_n$'(i') being an input.

As described above, the critical flow velocity calculation part 211 receives a result of the time history response analysis from the time history response analysis part 212 for each value of the negative damping ratio $\zeta_n$'(i') while changing the value of the negative damping ratio $\zeta_n$'(i'), and obtains a critical negative damping ratio $\zeta_{cr}$'(i'), which is the minimum negative damping ratio at which the change of the vibration amplitude of the heat-transfer tube bundle 10 diverges in the time history response analysis. Finally, the critical flow velocity calculation part 211 calculates the critical flow velocity Ucr(i') on the basis of the critical negative damping ratio $\zeta_{n\,cr}$(i') obtained as described above, and outputs the same to the self-excited vibration evaluation part 213. Upon receiving the critical flow velocity Ucr(i') corresponding to the eigenmode φ(i') from the critical flow velocity calculation part 211, the self-excited vibration evaluation part 213 compares the expected flow velocity of the fluid fl input from the input part 24 with the critical flow velocity Ucr(i'), and thereby evaluate self-excited vibration of the heat-transfer tube bundle 10 for each eigenmode. That is, in this embodiment, the time history response analysis is executed repeatedly with the negative damping ratio $\zeta_n$ being an input, while gradually increasing the negative damping ratio $\zeta_n$, and thereby the increase of the vibration amplitude is simulated.

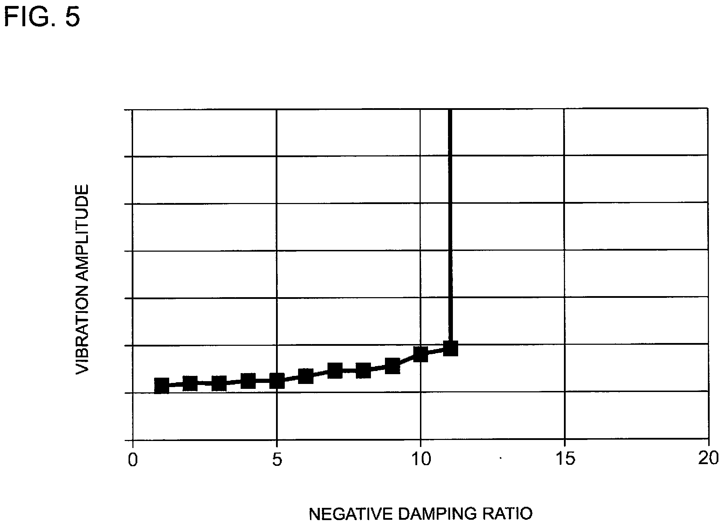

Further, with reference to FIG. 5, described below in detail is the process of obtaining the critical negative damping ratio $\zeta_n^{cr}$(i'), which is the minimum negative damping ratio at which the vibration amplitude of the heat-transfer tube bundle 10 diverges, as the critical flow velocity calculation part 211 shown in FIG. 4B calls the time history response analysis part 212 repeatedly. The curve graph in FIG. 5 represents a change in the vibration amplitude of the heat-transfer tube bundle 10 corresponding to the change in the value of the negative damping ratio $\zeta_n$(i') with respect to the eigenmode φ(i'). That is, in the curve graph of FIG. 5, the vibration amplitude calculated for each value of the negative damping ratio $\zeta_n$ is plotted, as the critical flow velocity calculation part 211 repeatedly executes the time history response analysis for obtaining the vibration amplitude of the heat-transfer tube bundle 10 as each value of the negative damping ratio $\zeta_n$(i') being an input, while gradually increasing the value of the negative damping ratio $\zeta_n$(i').

With reference to the curve graph of FIG. 5, when the value of the negative damping ratio $\zeta_n$(i') is not greater than ten, the vibration amplitude of the heat-transfer tube bundle 10 increases slightly with an increase in the negative damping ratio $\zeta_\eta$(i'), but substantially constant. However, when the value of the negative damping ratio $\zeta_n$(i') reaches eleven, the vibration amplitude of the heat-transfer tube bundle 10 increases rapidly. That is, the vibration amplitude of the heat-transfer tube bundle 10 diverges when the value of the negative damping ratio $\zeta_n$(i') reaches eleven, while the critical flow velocity calculation part 211 repeatedly executes the time history response analysis for obtaining the vibration amplitude of the heat-transfer tube bundle 10 as each value of the negative damping ratio $\zeta_n$(i') being an input, while gradually increasing the value of the negative damping ratio $\zeta_n$(i'). As described above, for each of the plurality of eigenmodes φ(i), it is possible to obtain the critical negative damping ratio $\zeta_n^{cr}$(i) corresponding to the critical point at which the vibration amplitude of the heat-transfer tube bundle 10 diverges, while the negative damping ratio $\zeta_n$(i) is gradually increased. Further, for each of the plurality of eigenmodes φ(i), it is possible to calculate the critical flow velocity Ucr(i) from the critical negative damping ratio $\zeta_n^{cr}$(i).

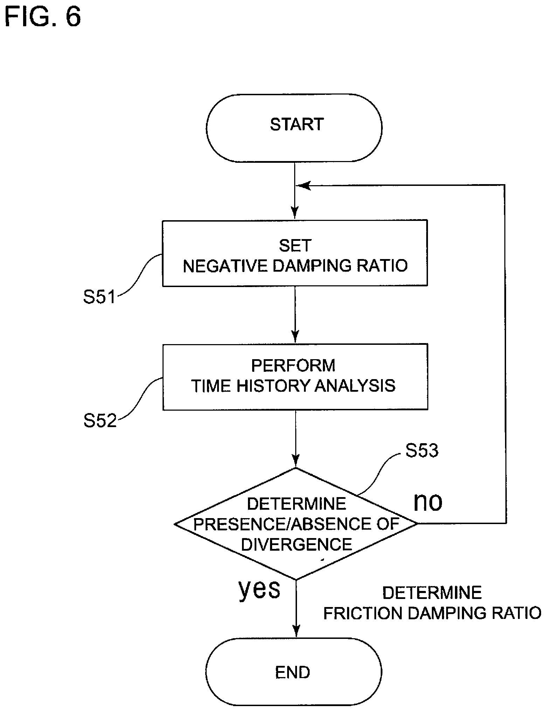

Next, according to some embodiments of the present invention, the execution process of the self-excited vibration evaluation method executed by the computer device 20 shown in FIGs. 4A and 4B will be described along the flow chart in FIG. 6. The flowchart shown in FIG. 6 shows the process of evaluating self-excited vibration of the heat-transfer tube bundle 10 for each of the plurality of eigenmodes φ(i)(1≤i≤l), corresponding to each of the plurality of eigen frequencies f(i)(1≤i≤l) of the heat-transfer tube bundle 10. The self-excited vibration evaluation method shown in the flowchart of FIG. 6 is realized focusing on the following basic characteristics related to the self-excited vibration of the heat-transfer tube bundle 10. That is, the minimum negative damping ratio $\zeta_n^{cr}$ at which the change of the vibration amplitude of the heat-transfer tube bundle 10 diverges corresponds to the maximum negative damping ratio that the vibration system expressing the heat-transfer tube bundle 10 can tolerate without causing self-excited vibration, which is the maximum friction damping ratio $\zeta_p^{max}$ that can be applied to suppress self-excited vibration. For one eigenmode φ(i), as the execution of the flowchart in FIG. 6 starts, in step S51, the critical flow velocity calculation part 211 sets an initial value of the negative damping ratio $\zeta_n$(i'), and passes the initial value of the negative damping ratio to the time history response analysis part 212.

Subsequently, the process advances to step S52, and the time history response analysis part 212, upon receiving the initial value of the negative damping ratio $\zeta_n$(i') from the critical flow velocity calculation part 211, executes the time history response analysis of simulating a change in the vibration amplitude of the heat-transfer tube bundle 10, with the negative damping ratio $\zeta_n$(i') being an input parameter. In an illustrative embodiment, the time history response analysis executed by the time history response analysis part 212 may include computation including time-series simulation of the vibration amplitude which occurs when the excitation force $F_{ex}$ corresponding to the negative damping ratio $\zeta n(i')$ is applied as an external force term to the vibration analysis model $H(\varphi,t)$ of the heat-transfer tube bundle 10. Furthermore, the vibration analysis model $(\varphi,x)$ may be a model which defines the magnitude of the friction force between the heat-transfer tube bundle 10 and the anti-vibration bar 12 by assuming the distribution of contact load applied between the heat-transfer tube bundle 10 and the anti-vibration bar 12. For instance, the vibration analysis model $H(\varphi,x)$ may be obtained by modelizing the magnitude of the friction force between the heat-transfer tube bundle 10 and the anti-vibration bar 12 as a component of additional stiffness and additional damping which should be reflected in the equation of motion that describes vibration of the heat-transfer tube bundle 10.

Next, the process advances to step S53, and the critical flow velocity calculation part 211 receives, from the time history response analysis part 212, the magnitude of the vibration amplitude of the heat-transfer tube bundle 10 obtained as a result of inputting the negative damping ratio $\zeta n(i')$ into the above described time history response analysis. Next, the critical flow velocity calculation part 211 determines whether the magnitude of the vibration amplitude of the heat-transfer tube bundle 10 diverges. In step S53, if it is determined that the magnitude of the vibration amplitude of the heat-transfer tube bundle 10 diverges, the critical flow velocity calculation part 211 sets the current value of the negative damping ratio $\zeta n(i')$ to the value of the critical negative damping ratio $\zeta_n{}^{cr}(i')$. Subsequently, the critical flow velocity calculation part 211 calculates the critical flow velocity Ucr(i') on the basis of value of the critical negative damping ratio $\zeta_n{}^{cr}(i')$, and passes the value of the critical flow velocity Ucr(i') to the self-excited vibration evaluation part 213. Next, the self-excited vibration evaluation part 213 receives the value of the critical flow velocity Ucr(i') from the critical flow velocity calculation part 211, receives the value of the expected flow velocity of the fluid fl from the input part 24, and then compares the value of the critical flow velocity Ucr(i') to the value of the expected flow velocity. Finally, from the result of the above comparison, the self-excited vibration evaluation part 213 determines presence or absence of self-excited vibration of the heat-transfer tube bundle 10 on the basis of the eigenmode $\varphi(i')$, and completes execution of the flowchart shown in FIG. 6.

In step S53, if it is determined that the magnitude of the vibration amplitude of the heat-transfer tube bundle 10 does not diverge, the execution of the flowchart of FIG. 6 returns to step S51, and in step S51, the value of the negative damping ratio $\zeta n(i')$ is increased by a slight displacement amount. Next, with the value of the negative damping ratio $\zeta n(i')$ increased by a slight displacement amount being an input, steps S52 and S53 are executed again. That is, the time history response analysis is executed again with the value of the negative damping ratio $\zeta n(i')$ increased by a slight displacement amount being an input, and if it is determined that the vibration amplitude of the heat-transfer tube bundle 10 accordingly obtained does not diverge, the process returns to step S51, where the value of the negative damping ratio $\zeta n(i')$ is increased further, and similar processes are repeatedly executed. In contrast, if it is determined that the vibration amplitude of the heat-transfer tube bundle 10 diverges for the value of the negative damping ratio $\zeta n(i')$ increased by a slight displacement amount, the current value of the negative damping ratio $\zeta n(i')$ is set to the value of the critical negative damping ratio $\zeta_n{}^{cr}(i')$, and the critical flow velocity Ucr is calculated on the basis of the critical negative damping ratio $\zeta_n{}^{cr}(i')$.

Herein, for a eigenmode $\varphi(i')$, the critical negative damping ratio $\zeta_n{}^{cr}(i')$ corresponding to the excitation force $F_{ex}$ applied when the flow velocity of the fluid is equal to the critical flow velocity Ucr(i') can be regarded as being in balance with the positive damping ratio $\zeta p(i')$ corresponding to the friction damping between the heat-transfer tubes 6 in the heat-transfer tube bundle 10 and the anti-vibration bar 12. Thus, in an illustrative embodiment, in step S53, the critical flow velocity calculation part 211 may calculate the critical flow velocity Ucr(i') from the value of the critical negative damping ratio $\zeta_n{}^{cr}(i')$ as follows. First, the critical flow velocity calculation part 211 assumes that the critical negative damping ratio $\zeta_n{}^{cr}(i')$ is equal to the damping ratio $\zeta p(i')$ which is determined from the structure of the heat-transfer tube bundle 10 of the critical negative damping ratio $\zeta_n{}^{cr}(i')$. Next, a logarithmic decrement $\delta$ corresponding to the damping ratio $\zeta p(i')$ is calculated, and the logarithmic decrement $\delta$ is substituted in the following expression to calculate the critical flow velocity (i').

(Expression 1)

$$\frac{U_{cr}}{fD} = K\sqrt{\frac{m\delta}{\rho D^2}}$$

Herein, the above expression (1) represents a relationship between the critical flow velocity Ucr, which is the minimum flow velocity that causes self-excited vibration (hydroelastic vibration) due to the hydrodynamic force of the heat-transfer tube bundle 10 in the fluid fl, and the logarithmic decrement $\delta$ determined from the structure of the heat-transfer tube bundle 10. In the above expression (1), f is the eigenfrequency corresponding to the eigenmode of the heat-transfer tube bundle 10, D is the diameter of the heat-transfer tubes 6, M is the mass per unit length of the heat-transfer tubes

6, $\rho$ is the mass density of the fluid, and K is the critical coefficient. In short, in this example, a computation expression for the critical flow velocity calculation part 211 to calculate the critical flow velocity Ucr(i') from the value of the critical negative damping ratio $\zeta_n^{cr}$(i') is defined on the basis of the stability determination expression of Connors for the hydroelastic vibration of the tube bundle.

Accordingly, for the eigenmode $\varphi$(i'), the self-excited vibration evaluation method described above with reference to FIGs. 4 to 6 includes calculating the critical flow velocity Ucr(i') of the fluid fl as follows. That is, the time history response analysis of simulating a change in the vibration amplitude of the heat-transfer tube bundle 10 is executed while changing the negative damping ratio $\zeta_n$(i') corresponding to the excitation force $F_{ex}$ of the fluid fl, and the critical flow velocity Ucr(i') of the fluid is calculated on the basis of the minimum negative damping ratio $\zeta_n^{cr}$(i') at which a change in the vibration amplitude diverges. Herein, the minimum negative damping ratio $\zeta_n^{cr}$ at which the change of the vibration amplitude of the heat-transfer tube bundle 10 diverges corresponds to the maximum negative damping ratio that the vibration system expressing the heat-transfer tube bundle 10 can tolerate without causing self-excited vibration, which is the maximum friction damping ratio $\zeta_p^{max}$ that can be applied to suppress self-excited vibration. As a result, according to this self-excited vibration evaluation method, it is possible to evaluate self-excited vibration appropriately taking account of the friction damping effect applied to the heat-transfer tube bundle 10, when the heat-transfer tube bundle 10 including the plurality of heat-transfer tubes 6 arranged in the fluid fl is supported by the friction force from the anti-vibration bar 12 against the excitation force $F_{ex}$ of the fluid fl.

Further, in this embodiment, the parameters changed with the flow velocity of the fluid is only the negative damping ratio corresponding to the excitation force $F_{ex}$ of the fluid fl. Herein, when modeling the heat-transfer tube bundle 10 as a multi-degree of freedom vibration system, the number of negative damping ratio to be changed in accordance with the fluid velocity of the fluid fl is equal to the number of at least one eigenmode $\varphi$(i) corresponding to the at least one eigenfrequency f(i) of the multi-degree of freedom vibration system. Furthermore, in the vibration analysis, it is normally possible to ignore the contribution of the negative damping ratio corresponding to a high-order eigenmode over a predetermined order to self-excited vibration. Thus, according to the present embodiment, regardless of the number of heat-transfer tubes 6 forming the heat-transfer tube bundle 10 and the structural complexity of the heat-transfer tube bundle 10, it is possible to obtain the critical flow velocity by changing only a predetermined extremely small number of parameters with the flow velocity, from among the parameters of the vibration analysis model of the heat-transfer tube bundle 10.

In an illustrative embodiment, the time history response analysis part 212 may simulate the change of the vibration amplitude of the heat-transfer tube bundle 10 by executing the time history response analysis as follows, with the negative damping ratio $\zeta_n$(i') being an input parameter. For instance, the excitation force $F_{ex}$ corresponding to the negative damping ratio $\zeta_n$(i') is a hydrodynamic force that the fluid around the heat-transfer tube bundle 10 applies to each of the heat-transfer tubes 6, and can be calculated as follows. That is, the hydrodynamic force may be calculated using a result obtained by solving the Poisson equation in relation to pressure to obtain a pressure filed in the heat-transfer tube bundle 10, and then solving the Navier-Stokes equation (N-S equation) to obtain a flow velocity field in the heat-transfer tube bundle 10, for the fluid surrounding the heat-transfer tube bundle 10.

Further, in this embodiment, the vibration analysis model H ($\varphi$,x) of the heat-transfer tube bundle 10 where the excitation force $F_{ex}$ corresponding to the negative damping ratio $\zeta_n$(i') is applied as an external force term may be described as a model where the following equivalent characteristics are added to the motion equation of the multi-degree of freedom vibration system simulating the vibration of the heat-transfer tube bundle 10. First, the first equivalent characteristics that can be added to the motion equation describing vibration of the heat-transfer tube bundle 10 are the fluid additional mass, the fluid additional stiffness, and the fluid additional damping, which are added to the vibration characteristics of the heat-transfer tube bundle 10 by the fluid surrounding the heat-transfer tube bundle 10. Further, the second equivalent characteristics that can be added to the motion equation describing vibration of the heat-transfer tube bundle 10 are the additional stiffness and the additional damping, which correspond to the friction damping effect of damping the excitation force $F_{ex}$ applied to the heat-transfer tubes 6 as the heat-transfer tubes 6 receive a friction force from the anti-vibration bar 12.

For instance, a motion equation obtained by reflecting the above described additional mass, additional stiffness, and additional damping in the motion equation of the multi-degree of freedom vibration system simulating mid-air vibration of the heat-transfer tube bundle 10 can be defined as follows.

(Expression 2)

$$[M_0 + M]\ddot{\mathbf{x}} + [C_0 + C]\dot{\mathbf{x}} + [K_0 + K]\mathbf{x} = \mathbf{0}$$

Herein, the vector x is a displacement vector representing the displacement due to vibration of the heat-transfer tube bundle 10, having an order corresponding to the degree of freedom of the heat-transfer tube bundle 10. Further,

$M_0$, $C_0$, and $K_0$ are the mass matrix, the damping matrix, and the stiffness matrix, respectively representing the mid-air unit length mass, the mid-air unit length structural damping, and the mid-air unit length stability stiffness, for the plurality of heat-transfer tubes 6 included in the heat-transfer tube bundle 10. Further, M, C, and K are each a matrix representing the additional mass, the additional damping, and the additional stiffness, respectively, which are added to the vibration characteristics of the heat-transfer tube bundle 10 corresponding to the friction damping effect generated as the fluid surrounding the heat-transfer tube bundle 10 and the heat-transfer tube 6 receive a friction force from the anti-vibration bar 12.

As follows, for instance, it is possible to calculate the vibration amplitude of the heat-transfer tube bundle 10 from the negative damping ratio $\zeta n(i)$ given as an input for each of the eigenmodes $\varphi(i)(1 \leq i \leq I)$ by using the above described vibration analysis model H $(\varphi, x)$. First, the negative damping vector Zn is defined as follows, which includes the plurality of eigenmodes $\zeta n(i)(1 \leq i \leq I)$ corresponding to the plurality of eigenmodes $(i)(1 \leq i \leq I)$ as elements.

(Expression 3)

$$Z_n = \left[ \xi_n(1), \xi_n(2), \xi_n(3), \cdots\cdots, \xi_n(I-1), \xi_n(I) \right]$$

Next, the forced vibration that is predicted to occur when the excitation force $F_{ex}$ corresponding to the negative damping ratio vector Zn is applied to the vibration analysis model H $(\varphi, x)$ as an external force term may be executed as simulation, to obtain the magnitude of the norm of the displacement vector x representing the vibration displacement of the heat-transfer tube bundle 10.

For instance, the time history response analysis part 212 may implement the above described time history response analysis as follows. First, the excitation force $F_{ex}$ corresponding to the negative damping ratio vector Zn is expressed as a function $F_{ex}(Z)$ where the negative damping ratio vector Zn is a parameter. In an example, the function $F_{ex}(Zn)$ may include a basis conversion that converts the eigenmode coordinate system to the coordinate system of the displacement vector. Next, with the excitation force $F_{ex}(Zn)$ corresponding to the negative damping ratio vector Zn being an external force term, forced vibration generated by applying the external force term to the vibration characteristics of the heat-transfer tube bundle 10 represented by the above expression (2) is assumed. Accordingly, the correlation between the negative damping ratio vector Zn and the displacement vector x is modelized as in the following expression (4).

(Expression 4)

$$[M_0 + M]\ddot{\mathbf{x}} + [C_0 + C]\dot{\mathbf{x}} + [K_0 + K]\mathbf{x} = F_{ex}(Z_n)$$

Then, the time history response analysis part 212 performs mode expansion of the expression (4) with the plurality of eigenmodes $\varphi(i)(1 \leq i \leq I)$, to obtain a model expression through the mode expansion, and executes a parametric study computation process of calculating backward the norm of the displacement vector x from the negative damping ratio $\zeta n(i)$ input to each eigenmode. Accordingly, the time history response analysis part 212 can realize the time history response analysis of calculating the vibration amplitude of the heat-transfer tube bundle 10 from the negative damping ratio $\zeta n(i')$ given as an input for each eigenmode.

As described above, in the present embodiment, after building the vibration analysis model H$(\varphi, x)$ which specifies the magnitude of the friction force between the anti-vibration bar 2 and each heat-transfer tube 6 in the heat-transfer tube bundle 10, the vibration amplitude which occurs when the excitation force $F_{ex}$ corresponding to the vector Zn is applied to the vibration analysis model H $(\varphi, x)$ is simulated in a time-series manner. Thus, according to this embodiment, it is possible to obtain the minimum negative damping ratio $\zeta_n^{cr}(i')$ at which the change of the vibration amplitude of the heat-transfer tube bundle 10 diverges for each eigenmode $\varphi(i')$, taking account of the effect that the friction force between the anti-vibration bar 12 and each heat-transfer tube 6 in the heat-transfer tube bundle 10 attenuates the excitation force $F_{ex}$ corresponding to the negative damping ratio vector Zn.

Further, in another illustrative embodiment, the time history response analysis part 212 may implement the above described time history response analysis including the following computation. First, the effective damping ratio $\zeta_{eff}$ of the heat-transfer tube bundle 10 is calculated on the basis of the offset relationship between the negative damping ratio $\zeta n$ and the first damping ratio (positive damping ratio) $\zeta p$ corresponding to the energy dissipation amount $E_{rd}$ of self-excited vibration that is dissipated in accordance with the friction force between the plurality of heat-transfer tubes 6 and the anti-vibration bar 12. Next, on the basis of the effective damping ratio $\zeta_{eff}$, the vibration amplitude of the heat-transfer tube bundle 10 is estimated.

In this embodiment, the effective damping ratio $\zeta_{eff}$ of the entire heat-transfer tube bundle 10 is calculated, focusing on the fact that there is an offset relationship between the negative damping ratio $\zeta n$ and the first damping ratio $\zeta p$ corresponding to the energy dissipation amount of self-excited vibration that is dissipated in accordance with the friction force between a tube bundle and a support member. Further, in this embodiment, on the basis of the effective damping ratio $\zeta_{eff}$, the vibration amplitude of the heat-transfer tube bundle 10 is estimated in a time-series manner. Thus, according to this embodiment, it is possible to evaluate the effect of dissipation of energy of self-excited vibration in accordance with the friction force between the plurality of heat-transfer tubes 6 and the anti-vibration bar 12 as an offset effect between the negative damping ratio $\zeta n$ and the first damping ratio $\zeta p$ corresponding to the energy dissipation amount. Further, according to this embodiment, it is possible to obtain the critical negative damping ratio $\zeta_n^{cr}$, which is the minimum negative damping ratio at which the change of the vibration amplitude of the heat-transfer tube bundle 10 diverges, taking into account the above offset effect.

Further, in another illustrative embodiment, the time history response analysis part 212 may implement the above described time history response analysis as follows. That is, the above described time history response analysis may include determining that the vibration amplitude diverges at the time when the negative damping ratio $\zeta n$ becomes equal to the first damping ratio $\zeta p$, in accordance with a change in the vibration amplitude of the heat-transfer tube bundle 10.

Further, in this embodiment, the negative damping ratio $\zeta n$ increases non-linearly with the vibration amplitude of the heat-transfer tube bundle 10, while the first damping ratio $\zeta p$ is modelized as having a characteristic that decreases non-linearly with the vibration amplitude. That is, since the damping ratio $\zeta$ in a vibration system is a ratio obtained by dividing the dissipation amount of excitation energy by energy corresponding to the vibration amplitude, the greater the vibration amplitude of the heat-transfer tubes 6, the smaller the first damping ratio $\zeta p$ corresponding to the friction force from the anti-vibration bar 12. In contrast, between adjacent heat-transfer tubes 6, the vibration of the heat-transfer tubes 6 act as the excitation force $F_{ex}$ with an increase in the vibration amplitude. Thus, the negative damping ratio $\zeta n$ increases non-linearly with an increase in the vibration amplitude. Further, in the repeating process executed by the critical flow velocity calculation part 211, the time history response analysis is executed repeatedly with the negative damping ratio $\zeta n$ being an input, while gradually increasing the negative damping ratio $\zeta n$, and thereby the increase of the vibration amplitude is simulated. Thus, in this embodiment, it may be determined that the vibration amplitude diverges at the time when the negative damping ratio $\zeta n$ which increases non-linearly with an increase in the vibration amplitude of the heat-transfer tube bundle 10 becomes equal to the first damping ratio $\zeta p$ which decreases non-linearly with an increase in the vibration amplitude.

Accordingly, also in this embodiment, the vibration amplitude is evaluated on the basis of an offset effect between the negative damping ratio $\zeta n$ corresponding to the excitation force $F_{ex}$ of the fluid fl and the first damping ratio $\zeta p$ corresponding to the energy dissipation amount of self-excited vibration, thereby obtaining the minimum negative damping ratio $\zeta_n^{cr}$ at which the change of the vibration amplitude of the heat-transfer tube bundle 10 diverges, taking account of the offset effect. Further, in this embodiment, it is determined that the vibration amplitude of the heat-transfer tube bundle 10 diverges at the time when the negative damping ratio $\zeta n$ becomes equal to the first damping ratio $\zeta p$, in accordance with a change in the vibration amplitude of the heat-transfer tube bundle 10. As a result, according to this embodiment, it is possible to estimate the negative damping ratio $\zeta_n^{cr}$ corresponding to the excitation force $F_{ex}$ of the fluid at the time of the critical flow velocity as the negative damping ratio that balances with the first damping ratio $\zeta_p^{max}$ corresponding to the energy dissipation amount of self-excited vibration at the time of the critical flow velocity.

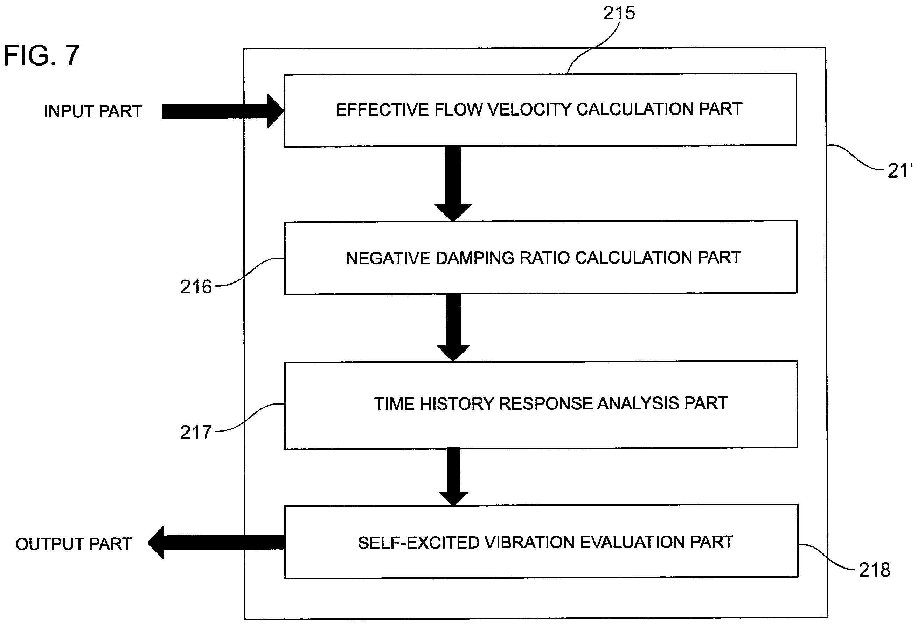

The self-excited vibration evaluation method according to the embodiment described with reference to FIGs. 4 to 6 is capable of predicting the critical flow velocity at which the heat-transfer tube bundle 10 disposed in the fluid fl causes self-excited vibration. Furthermore, in yet another embodiment of the present invention, the self-excited vibration evaluation method of the heat-transfer tube bundle 10 may include determining whether the heat-transfer tube bundle 10 causes self-excited vibration when the flow velocity of the fluid fl is input as an expected flow velocity. FIG. 7 is a diagram illustrating the internal configuration of a computation part 21' of a computer device 20' for executing the self-excited vibration evaluation method according to this embodiment. The configuration of the computer device 20' is the same as the computer device 20 shown in FIG. 4A, except that the computation part 21 is replaced with the computation part 21'.

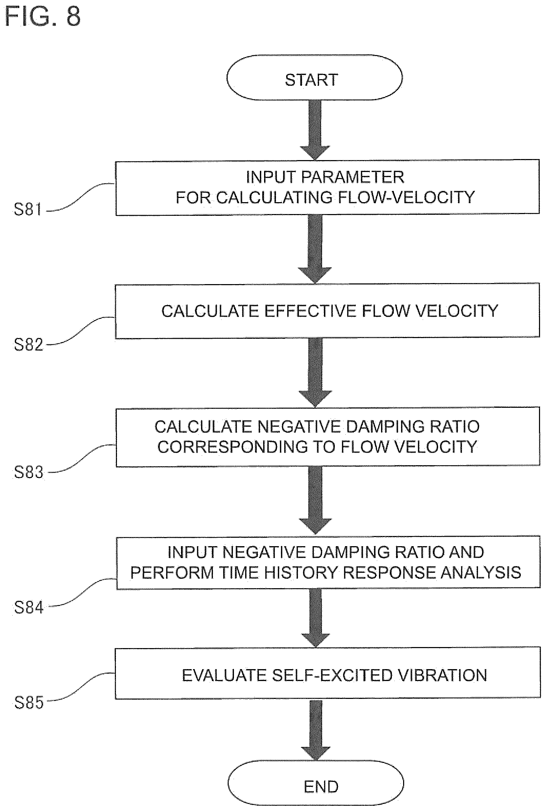

With reference to FIG. 7, the computation part 21' includes an effective flow velocity calculation part 215, a negative damping ratio calculation part 216, a time history response analysis part 217, and a self-excited vibration evaluation part 218. Furthermore, the effective flow velocity calculation part 215, the negative damping ratio calculation part 216, the time history response analysis part 217, and the self-excited vibration evaluation part 218 of the computation part 21' executes the self-excited vibration evaluation method according to this embodiment, according to the flow chart shown in FIG. 8. In an example, the computation part 21 may be realized by a general-purpose processor. In this case, the effective flow velocity calculation part 215, the negative damping ratio calculation part 216, the time history response analysis part 217, and the self-excited vibration evaluation part 218 may be realized as a program module which is to be generated in the computation part 21 as the computation part 21 reads in the program 22a from the memory part 22.

Hereinafter, assuming that self-excited vibration evaluation corresponding to the eigenmode φ(i') is performed, the operation of the effective flow velocity calculation part 215, the negative damping ratio calculation part 216, the time history response analysis part 217, and the self-excited vibration evaluation part 218 will be described, referring to the flowchart shown in FIG. 8.

First, in the step S81 of FIG. 8, the effective flow velocity calculation part 215 receives a flow velocity calculation parameter described below from the input part 24, and starts the process for obtaining the expected flow velocity. Next, in step S82, the effective flow velocity calculation part 215 calculates the effective flow velocity Ue of the fluid fl flowing inside and outside the heat-transfer tubes 6 as the expected flow velocity. In an illustrative embodiment, the effective flow velocity Ue of the fluid fl may be calculated on the basis of a distribution along the length direction y of each heat-transfer tube 6, of at least one of the dynamic pressure of the fluid fl applied to each heat-transfer tube 6 of the heat-transfer tube bundle 10, the density of each heat-transfer tube 6, or the vibration amplitude of each heat-transfer tube 6.

In this embodiment, the parameter for calculating the flow velocity may include distribution data of values of the fluid density p(y), the flow velocity U(y) of the fluid, the mass density m(y) per unit length of the heat-transfer tube 6, and the mode shape ψ(y), distributed along the length direction y of the heat-transfer tubes 6. Herein, the fluid density p(y) is estimated by adding both of the density distribution along the length direction y of the fluid flowing through the heat-transfer tubes 6 and the density distribution of the displacement volume of the fluid outside the heat-transfer tubes displaced by the heat-transfer tubes 6. Further, the mode shape ψ(y) is the displacement amount of the heat-transfer tubes 6 displaced from the reference shape in the length directional position y of the heat-transfer tubes 6 due to vibration, which is quantified taking account of the relative amplitude rate between the plurality of eigenmodes φ(i)(1≤i≤I). That is, the flow velocity U, the fluid density p, and the heat-transfer tube density m that affect evaluation of the vibration amplitude of the heat-transfer tubes 6 vary depending on the length directional position y of the heat-transfer tubes 6. Thus, the distribution of the above values along the length direction y of the heat-transfer tubes 6 is taken into account to obtain the effective flow velocity Ue as an effective flow velocity corresponding to the excitation force $F_{ex}$ applied to the heat-transfer tubes 6.

For instance, in an illustrative embodiment, the effective flow velocity calculation part 215 may use the above described parameters for calculating the flow velocity to calculate the effective flow velocity Ue on the basis of the following expression.

(Expression 5)

$$U_e = \left[ \frac{\int_0^l \frac{\rho(y)}{\rho_0} U^2(y)\varphi^2(y)dy}{\int_0^l \frac{m(y)}{m_0} \varphi^2(y)dy} \right]^{1/2}$$

In the expression (5), "$\rho_0$" and "$m_0$" are predetermined constants, and "l" is the length of the heat-transfer tubes 6. Further, the numerator of the above expression (5) is calculated as follows. First, the fluid density p(y) is multiplied by the square of the flow velocity U(y) of the fluid in the length directional position y of the heat-transfer tubes 6, to obtain the dynamic pressure of the fluid fl applied to the heat-transfer tubes 6 at the length directional position y. Next, the square of the mode shape is multiplied by the dynamic pressure at the length directional position y, and the result of multiplication is linear-integrated with the length 1 of the heat-transfer tubes 6 along the length direction y. That is, the numerator of the above expression (5) is equivalent to an average of the dynamic pressure of the fluid fl applied to the heat-transfer tubes 6, weighted with the square of the mode shape ψ(y) at the length directional position y. Further, the denominator of the above expression (5) is an average of the mass density at the length directional position y of the heat-transfer tubes 6, weighted with the square of the mode shape and linear-integrated along the length direction y.

Next, the execution of the flowchart of FIG. 8 advances to step S83, and the negative damping ratio calculation part 216 executes a process of receiving the effective flow velocity Ue from the effective flow velocity calculation part 215, and calculating the negative damping ratio ζn(i') using the effective flow velocity Ue as an expected flow velocity. Specifically, the negative damping ratio calculation part 216 assumes that the above described expected flow velocity is a provisional critical flow velocity Ucr(i'), and calculates a specific value of the negative damping ratio ζn(i') corresponding to the expected flow velocity, on the basis of a correlation between the critical flow velocity Ucr(i') and the negative damping ratio ζn(i') of the entire heat-transfer tube bundle 10.

In an illustrative embodiment, the negative damping ratio calculation part 216 may calculate the negative damping ratio ζn(i') from the effective flow velocity Ue assumed to be the provisional critical flow velocity, from the following expression.

(Expression 6)

$$\zeta_n(i') = \left(\frac{U_{cr}}{f}\right)^2 \frac{\rho}{2\pi m K} \left(\frac{U_e}{U_{cr}}\right)^2 = \left(\frac{U_e}{f}\right)^2 \frac{\rho}{2\pi m K}$$

The above expression (6) is a relational expression derived from the above expression (1). Specifically, the above expression (1) is rewritten into an expression having the logarithmic decrement δ on the left side, and the logarithmic decrement δ is substituted by $2\pi \times \zeta p(i')$, focusing on the fact that the value dividing the logarithmic decrement δ by $2\pi$ equals to the damping ratio $\zeta p(i')$. As a result, obtained is a relational expression defining a relation between the critical flow velocity Ucr(i'), which is the minimum flow velocity that causes self-excited vibration (hydroelastic vibration) due to the hydrodynamic force of the heat-transfer tube bundle 10 in the fluid fl, and the friction damping ratio $\zeta p$ defined by the friction damping structure of the heat-transfer tube bundle 10. Then, the relational expression between the critical flow velocity Ucr(i') and the friction damping ratio $\zeta p(i')$ is multiplied by the non-dimensional flow velocity $(Ue/Ucr(i'))^2$, thus obtaining the above expression (6).

That is, provided that stability limit refers to a state at the moment when the heat-transfer tube bundle 10 in the fluid fl starts self-excited vibration while the flow velocity of the fluid fl is increased, the above expression (1) defines the relationship between the flow velocity at the stability limit and the friction damping ratio $\zeta p(i')$ defined by the friction damping structure of the heat-transfer tube bundle 10. In other words, the above expression (1) is a conversion expression for converting the flow velocity at the stability limit into the friction damping ratio $\zeta_p^{max}(i')$ of the heat-transfer tube bundle 10 at the stability limit. Furthermore, as described above, the critical negative damping ratio $\zeta_n^{cr}(i')$ corresponding to the excitation force $F_{ex}$ applied when the flow velocity of the fluid is equal to the critical flow velocity Ucr(i') is in balance with the positive damping ratio $\zeta p(i')$ corresponding to the friction damping between the heat-transfer tubes 6 in the heat-transfer tube bundle 10 and the anti-vibration bar 12. Thus, by further multiplying the above relational expression with the square of a ratio of the effective flow velocity Ue to the flow velocity at the stability limit, it is possible to obtain an expression for obtaining the negative damping ratio $\zeta n(i')$, corresponding to the excitation force $F_{ex}$ that increases as the effective flow velocity Ue becomes closer to the flow velocity at the stability limit.

Next, as the execution of the flowchart of FIG. 8 advances to step S84, the time history response analysis part 217 inputs a specific value of the negative damping ratio $\zeta n(i')$ into the computation that simulates self-excited vibration of the heat-transfer tube bundle 10, and executes the computation. Specifically, in step S83, the time history response analysis part 217 executes time history response analysis by using a specific value of the negative damping ratio $\zeta n(i')$ received as an input, and calculates the magnitude of the vibration amplitude of the heat-transfer tube bundle 10. The time history response analysis executed by the time history response analysis part 217 is a computation similar to the time history response analysis described above with reference to FIGs. 4 to 6. That is, the time history response analysis is parametric study computation which calculates the vibration amplitude of the heat-transfer tube bundle 10 in a case where an excitation force $F_{ex}$ corresponding to the negative damping ratio $\zeta n(i')$ is applied to the heat-transfer tube bundle 10, with the value of the negative damping ratio $\zeta n(i')$ being an input.

Next, the execution of the flowchart in FIG. 8 advances to step S85. In step S84, the self-excited vibration evaluation part 218 determines whether the vibration amplitude of the heat-transfer tube bundle 10 diverges, on the basis of the result of time history response analysis executed by the time history response analysis part 217 using a specific value of the negative damping ratio $\zeta n(i')$. Further, the self-excited vibration evaluation part 218 evaluates self-excited vibration of the heat-transfer tube bundle 10 on the basis of the determination result. Specifically, the self-excited vibration evaluation part 218 receives vibration amplitude of the heat-transfer tube bundle 10 from the time history response analysis part 217 after performing time history response analysis using a specific value of the negative damping ratio $\zeta n(i')$. Next, the self-excited vibration evaluation part 218 determines whether the vibration amplitude diverges. For instance, the self-excited vibration evaluation part 218 may be configured to determine whether the vibration amplitude exceeds a predetermined threshold, and determine that the vibration amplitude diverges if the vibration amplitude exceeds the predetermined threshold. Finally, if the vibration amplitude diverges, the self-excited vibration evaluation part 218 predicts that self-excited vibration of the heat-transfer tube bundle 10 occurs when the excitation force $F_{ex}$ corresponding to the given effective flow velocity Ue is applied to the heat-transfer tube bundle 10, and ends the execution of the flowchart.

As described above, in the embodiment described with reference to FIGs. 7 and 8, the parametric study computation of a high calculation cost is not executed repeatedly and frequently as in the embodiments described with reference to FIGs. 4 to 6, but to check whether the heat-transfer tube bundle 10 causes self-excited vibration (unstable vibration) at a particular flow velocity (effective flow velocity Ue). Specifically, provided that the particular flow velocity Ue is the critical flow velocity, in the present embodiment, the damping ratio $\zeta n(i')$ at the time is calculated backward from the above expression (6), and the damping ratio $\zeta n(i')$ is given as an input to the time history response analysis (parametric study computation), and if the vibration amplitude of the heat-transfer tube bundle 10 does not diverge, the flow velocity Ue can be confirmed as being stable. In another perspective, in this embodiment, the effective flow velocity Ue suitable for an actual operational condition is assumed to be a provisional critical flow velocity, and then the negative damping ratio $\zeta n(i')$ under the operational condition (flow velocity Ue) is obtained. Further, if the vibration system is actually stable at the operational condition (flow velocity Ue) at the time, the negative damping ratio $\zeta n(i')$ at the time is a negative damping ratio that is estimated to be greater than the actual negative damping ratio. Thus, the vibration amplitude does not diverge even if the negative damping ratio $\zeta n(i')$ at the time is input to the parametric study computation, and thus it can be confirmed that self-excited vibration does not occur under the operation condition (flow velocity Ue) at the time.

Accordingly, in the above embodiment described above with reference to FIGs. 7 and 8, the obtained expected flow velocity is assumed to be the provisional critical flow velocity, and computation of simulating the self-excited vibration of the heat-transfer tube bundle 10 is executed by inputting the negative damping ratio $\zeta n(i')$ corresponding to the assumed provisional critical flow velocity, and it is determined whether self-excited vibration occurs on the basis of whether the vibration amplitude of the heat-transfer tube bundle 10 diverges. In other words, in this embodiment, it is checked if the provisional critical flow velocity exceeds the actual critical flow velocity $Ucr(i')$, on the basis of whether vibration amplitude of the heat-transfer tube bundle 10 diverges, when calculation of simulating self-excited vibration of the heat-transfer tube bundle 10 is executed on the basis of the provisional critical flow velocity. Thus, according to the present embodiment, through the simulation computation that simulates self-excited vibration of the heat-transfer tube bundle 10, it is possible to accurately predict whether self-excited vibration of the heat-transfer tube bundle 10 actually occurs when the fluid flows at the flow velocity assumed to be the provisional critical flow velocity.

In this embodiment, the effective flow velocity Ue of the fluid fl is calculated on the basis of a distribution along the length direction y of the above dynamic pressure of the fluid fl applied to each heat-transfer tube 6 of the heat-transfer tube bundle 10, the mass density of each heat-transfer tube 6, or the vibration amplitude of each heat-transfer tube 6, if the dynamic pressure, the density, or the vibration amplitude varies along the length direction y. Then, in this embodiment, the negative damping ratio $\zeta n(i')$ is calculated assuming that the effective flow velocity Ue is the provisional critical flow velocity. Thus, according to this embodiment, even if the dynamic pressure of the fluid fl applied to each heat-transfer tube 6 of the heat-transfer tube bundle 10, the density of each heat-transfer tube 6, or the vibration amplitude of each heat-transfer tube 6 varies along the length direction y of each heat-transfer tube 6, it is possible to obtain a single flow velocity value for calculating the negative damping ratio $\zeta n(i')$, taking into account a difference in the flow velocity by the location in the heat-transfer tube 6.

Further, in yet another embodiment, the negative damping ratio $\zeta n(i')$ to be given as an input to the time history response analysis (parametric study computation) may be calculated as follows, instead of calculating the same from the effective flow velocity Ue. That is, in this embodiment, through complex eigenvalue decomposition of the model representing the heat-transfer tube bundle 10 as the freedom vibration system, the positive damping ratio $\zeta p(i)$ corresponding to the friction damping generated by the friction force between the heat-transfer tubes 6 and the anti-vibration bar 12 in the heat-transfer tube bundle 10 is calculated for each of the plurality of eigenmodes $\varphi(i)(1 \leq i \leq I)$. Further, the negative damping ratio $\zeta n(i)$ is obtained for each of the plurality of eigenmodes $\varphi(i)(1 \leq i \leq I)$, from the absolute value of the positive damping value $\zeta p(i)$ corresponding to the friction damping effect that the heat-transfer tube bundle 10 possesses structurally. This is because, as described above, the critical negative damping ratio $\zeta_n{}^{cr}(i')$ corresponding to the excitation force $F_{ex}$ applied when the flow velocity of the fluid is equal to the critical flow velocity $Ucr(i')$ is in balance with the positive damping ratio $\zeta p(i')$ corresponding to the friction damping between the heat-transfer tubes 6 in the heat-transfer tube bundle 10 and the anti-vibration bar 12.

Specifically, in this embodiment, the vibration analysis model is built as a freedom vibration system where the external force term corresponding to the excitation force $F_{ex}$ applied to the heat-transfer tube bundle 10 is zero. Similarly, in this embodiment, the above vibration analysis model includes the additional mass, the additional damping, and the additional stiffness, respectively, which are added to the vibration characteristics of the heat-transfer tube bundle 10 corresponding to the friction damping effect generated as the fluid surrounding the heat-transfer tube bundle 10 and the heat-transfer tube 6 receive a friction force from the anti-vibration bar 12. In other words, in this embodiment, when the heat-transfer tube bundle 10 is disposed in a hydrodynamic field including a pressure field defined by the Poisson equation and a flow velocity field defined by the Navier-Stokes equation (N-S equation), the negative damping ratio $\zeta n(i')$ is obtained without directly taking into account the excitation force $F_{ex}$ that the heat-transfer tube bundle 10 receives from the fluid fl.

Next, in this embodiment, the time history response analysis is executed using a specific value of the negative damping ratio $\zeta n(i)$ obtained as described above for each of the plurality of eigenmodes $\varphi(i)(1 \leq i \leq I)$, and the magnitude of the vibration amplitude of the heat-transfer tube bundle 10 is calculated. The time history response analysis is a computation similar to the time history response analysis described above with reference to FIGs. 4 to 6. That is, the time history response analysis is parametric study computation which calculates the vibration amplitude of the heat-transfer tube bundle 10 in a case where an excitation force $F_{ex}$ corresponding to the negative damping ratio $\zeta n(i')$ is applied to the heat-transfer tube bundle 10, with the value of the negative damping ratio $\zeta n(i')$ being an input.

In an example, in this embodiment, through complex eigenvalue decomposition of the model representing the heat-transfer tube bundle 10 as the freedom vibration system, the negative damping ratio $\zeta n(i)$ may be calculated for each of the plurality of eigenmodes $\varphi(i)(1 \leq 1 \leq I)$. Firstly, the motion equation of the above expression (2) is rewritten into a state space expression and deformed into the following expression.

## (Expression 7)

$$\left[ -\begin{bmatrix} K_0 + K & \mathbf{0} \\ \mathbf{0} & -M \end{bmatrix} \begin{bmatrix} C_0 + C & M \\ M & \mathbf{0} \end{bmatrix}^{-1} - \lambda \mathbf{I} \right] = \mathbf{0}$$

Further, by solving the general eigenvalue problem defined by the above expression (7), a plurality of eigenvalues $(i)(1 \leq i \leq I)$ are obtained corresponding to the plurality of eigenmodes $\varphi(i)(1 \leq i \leq I)$, for the vibration characteristics of the heat-transfer tube bundle 10 represented by the motion equation of the above expression (2). Next, from the following expression, the negative damping ratio $\zeta n(i)$ and the eigenfrequency $\omega(i)$ corresponding to each of the plurality of eigenmodes $\varphi(i)(1 \leq i \leq I)$ are obtained from the plurality of eigenvalues $\lambda(i)(1 \leq i \leq I)$.

## (Expression 8)

$$\zeta_n(i) = -\operatorname{Re}(\lambda(i))/abs(\lambda(i))$$
$$\omega_n = \operatorname{Im}(\lambda(i))$$

Accordingly, in this embodiment, by building the vibration analysis model as the free vibration system where the external force term corresponding to the excitation force $F_{ex}$ applied to the heat-transfer tube bundle 10 is zero, it is possible to calculate a value appropriate for the negative damping ratio $\zeta n(i)$ to be input to the time history response analysis without performing detailed analysis of the hydrodynamic field applied to the heat-transfer tube bundle 10 as an external force, only by performing complex eigenvalue decomposition on the motion equation of the free vibration system.

Reference Signs List

| | |
|---|---|
| 3 | Heat-transfer tube |
| 4 | First span of straight tube portion |
| 5 | Second span of straight tube portion |
| 6 (6a1, 6a2, 6a3, 6b1, 6c1) | Bend portion |
| 7 | Tube support plate |
| 8 | Tube row |
| 10 | Heat-transfer tube bundle |
| 10a | Bend portion |
| 11 | First retaining bar |
| 12 | Anti-vibration bar |
| 12a | End portion |
| 14 | Second retaining bar |
| 20 | Computer device |
| 21 | Computation part |
| 22 | Memory part |
| 22a | Program |
| 22b | Data |
| 23 | Output part |
| 24 | Input part |
| 211 | Critical flow velocity calculation part |

| 212, 217 | Time history response analysis part |
|---|---|
| 213, 218 | Self-excited vibration evaluation part |
| 215 | Effective flow velocity calculation part |
| 216 | Negative damping ratio calculation part |
| D1 | In-plane direction |
| D2 | Out-of-plane direction |
| $E_{rd}$ | Energy dissipation amount |
| $F_{ex}$ | Function |
| $F_{ex}$ | Excitation force |
| H | Vibration analysis model |
| U, Ue | Flow velocity |
| Ucr | Critical flow velocity |
| Ue | Effective flow velocity |
| d1, d2 | Row direction |
| f | Eigen frequency |
| fl | Fluid |
| m | Mass density of heat transfer tube |
| x | Displacement vector |
| y | Length directional position |

**Claims**

1. A self-excited vibration evaluation method for evaluating self-excited vibration of a tube bundle (10) arranged in a fluid so as to be supported by a support member (7), taking account of the friction damping effect applied to the tube bundle (10), the method comprising:

   for each of at least one eigenmode of the tube bundle (10),
   a time history response analysis step of performing time history response analysis of obtaining the vibration amplitude of the tube bundle (10) as each value of a negative damping ratio being an input, while gradually increasing the value of the negative damping ratio corresponding to an excitation force of the fluid;
   a critical flow velocity calculation step of obtaining a critical negative damping ratio corresponding to a critical point at which the vibration amplitude of the tube bundle (10) diverges in the time history response analysis, while the negative damping ratio is gradually increased, and calculating a critical flow velocity from the critical negative damping ratio;
   an input step of inputting an expected flow velocity of the fluid; and
   an evaluation step of evaluating the self-excited vibration of the tube bundle (10) for each eigenmode by comparing the expected flow velocity of the fluid with the critical flow velocity,
   wherein the time history response analysis includes calculation which includes time-series simulation of vibration amplitude which occurs when an excitation force corresponding to the negative damping ratio is applied as an external force term to a vibration analysis model of the tube bundle (10), and
   wherein the vibration analysis model determines a magnitude of a friction force between the tube bundle (10) and the support member (7), by assuming a distribution of a contact load acting between the tube bundle (10) and the support member (7).

2. The self-excited vibration evaluation method according to claim 1,
   wherein the time history response analysis includes:

   calculating an effective damping ratio of the tube bundle (10) on the basis of an offset relationship between the negative damping ratio and a first damping ratio corresponding to an energy dissipation amount of the self-excited vibration dissipated in accordance with a friction force between the tube bundle (10) and the support member (7); and
   performing time-series estimation of the vibration amplitude of the tube bundle (10) on the basis of the calculated effective damping ratio.

3. The self-excited vibration evaluation method according to claim 2,
   wherein the time history response analysis includes:
   determining that the vibration amplitude diverges at the time when the negative damping ratio becomes equal to the first damping ratio as the vibration amplitude of the tube bundle (10) changes.

4. The self-excited vibration evaluation method according to any one of claims 1 to 3,

   wherein the tube bundle (10) includes at least one tube row (8) formed by a plurality of U-shaped tubes (3) extending within the same plane and sharing a curvature center with one another, the U-shaped tubes (3) including bend portions (6) having different curvature radii from one another,
   wherein the support member includes at least one pair of anti-vibration bars (12) disposed on both sides of the tube row (8) so as to extend along the plane across the tube row (8), and
   wherein the method includes determining stability of hydroelastic vibration in a direction along the plane of the tube bundle (10) supported by a friction force between the anti-vibration bars (12) and the tube bundle (10) against an excitation force of the fluid flowing through the tube bundle (10).

5. The self-excited vibration evaluation method according to any one of claims 1 to 4,
   wherein the tube bundle comprises a bundle (10) of heat-transfer tubes (3) of a steam generator of a PWR nuclear power plant.

**Patentansprüche**

1. Beurteilungsverfahren für selbsterregte Schwingung zum Beurteilen einer selbsterregten Schwingung eines Rohrbündels (10), das in einem Fluid angeordnet ist, um von einem Stützelement (7) gestützt zu werden, unter Berücksichtigung eines Reibungsdämpfungseffekts, der auf das Rohrbündel (10) angewendet wird, wobei das Verfahren Folgendes umfasst:

   für jede von mindestens einer Eigenmode des Rohrbündels (10),
   einen Zeitverlaufsansprechanalyseschritt zum Durchführen einer Zeitverlaufsansprechanalyse zum Erhalten der Schwingungsamplitude des Rohrbündels (10), wobei jeder Wert eines negativen Dämpfungsverhältnisses eine Eingabe ist, während der Wert des negativen Dämpfungsverhältnisses, der einer Anregungskraft des Fluids entspricht, schrittweise erhöht wird;
   einen Berechnungsschritt für eine kritische Fließgeschwindigkeit zum Erhalten eines kritischen negativen Dämpfungsverhältnisses, das einem kritischen Punkt entspricht, bei dem die Schwingungsamplitude des Rohrbündels (10) in der Zeitverlaufsansprechanalyse divergiert, während das negative Dämpfungsverhältnis schrittweise erhöht wird, und Berechnen einer kritischen Fließgeschwindigkeit aus dem kritischen negativen Dämpfungsverhältnis;
   einen Eingabeschritt zum Eingeben einer erwarteten Fließgeschwindigkeit des Fluids; und
   einen Beurteilungsschritt zum Beurteilen der selbsterregten Schwingung des Rohrbündels (10) für jede Eigenmode durch Vergleichen der erwarteten Fließgeschwindigkeit des Fluids mit der kritischen Fließgeschwindigkeit, wobei die Zeitverlaufsansprechanalyse eine Berechnung beinhaltet, die eine Zeitreihensimulation einer Schwingungsamplitude beinhaltet, die auftritt, wenn eine Anregungskraft, die dem negativen Dämpfungsverhältnis entspricht, als ein externer Kraftterm an ein Schwingungsanalysemodell des Rohrbündels (10) angelegt wird, und
   wobei das Schwingungsanalysemodell durch die Annahme einer Verteilung einer Kontaktlast, die zwischen dem Rohrbündel (10) und dem Stützelement (7) wirkt, eine Größe einer Reibkraft zwischen dem Rohrbündel (10) und den Stützelementen (7) bestimmt.

2. Beurteilungsverfahren für selbsterregte Schwingung nach Anspruch 1,
   wobei die Zeitverlaufsansprechanalyse Folgendes beinhaltet:

   Berechnen eines effektiven Dämpfungsverhältnisses des Rohrbündels (10) auf Basis einer Versatzbeziehung zwischen dem negativen Dämpfungsverhältnis und einem ersten Dämpfungsverhältnis, das einer Energiedissipationsmenge der selbsterregten Schwingung entspricht, die gemäß einer Reibkraft zwischen dem Rohrbündel (10) und dem Stützelement (7) dissipiert wird; und
   Durchführen einer Zeitreihenschätzung der Schwingungsamplitude des Rohrbündels (10) auf Basis des berechneten effektiven Dämpfungsverhältnisses.

3. Beurteilungsverfahren für selbsterregte Schwingung nach Anspruch 2,
   wobei die Zeitverlaufsansprechanalyse Folgendes beinhaltet:

Bestimmen, dass zu der Zeit, wenn das negative Dämpfungsverhältnis gleich dem ersten Dämpfungsverhältnis wird, wenn sich die Schwingungsamplitude des Rohrbündels (10) ändert, die Schwingungsamplitude divergiert.

4. Beurteilungsverfahren für selbsterregte Schwingung nach einem der Ansprüche 1 bis 3,

wobei das Rohrbündel (10) mindestens eine Rohrreihe (8) beinhaltet, die durch eine Vielzahl von U-förmigen Rohren (3) gebildet wird, die sich in derselben Ebene erstrecken und in einem gemeinsamen Krümmungszentrum liegen, wobei die U-förmigen Rohre (3) Biegungsabschnitte (6) mit voneinander abweichenden Krümmungsradien beinhalten,
wobei das Stützelement mindestens ein Paar Schwingungsdämpfungsstäbe (12) beinhaltet, die auf beiden Seiten der Rohrreihe (8) angeordnet sind, um sich entlang der Ebene über die Rohrreihe (8) zu erstrecken, und wobei das Verfahren das Bestimmen einer Stabilität einer hydroelastischen Schwingung in einer Richtung entlang der Ebene des Rohrbündels (10) beinhaltet, das durch eine Reibkraft zwischen den Schwingungsdämpfungsstäben (12) und dem Rohrbündel (10) gegen eine Anregungskraft des Fluids gestützt wird, das durch das Rohrbündel (10) fließt.

5. Beurteilungsverfahren für selbsterregte Schwingung nach einem der Ansprüche 1 bis 4, wobei das Rohrbündel ein Bündel (10) von Wärmeübertragungsrohren (3) eines Dampfgenerators eines PWR-Kernkraftwerks umfasst.

## Revendications

1. Procédé d'évaluation de vibration auto-excitée pour l'évaluation d'une vibration auto-excitée d'un faisceau de tubes (10) agencé dans un fluide de façon à être porté par un organe support (7), prenant en compte l'effet d'amortissement par friction appliqué au faisceau de tubes (10), le procédé comprenant :

pour chacun d'au moins un mode propre du faisceau de tubes (10),
une étape d'analyse de réponse historique temporelle dans laquelle on réalise une analyse de réponse historique temporelle dans laquelle on obtient l'amplitude de vibration du faisceau de tubes (10), chaque valeur d'un taux d'amortissement négatif étant une entrée, tout en augmentant graduellement la valeur du taux d'amortissement négatif correspondant à une force d'excitation du fluide ;
une étape de calcul de vitesse d'écoulement critique dans laquelle on obtient un taux d'amortissement négatif critique correspondant à un point critique auquel l'amplitude de vibration du faisceau de tubes (10) diverge dans l'analyse de réponse historique temporelle, tandis que le taux d'amortissement négatif est graduellement augmenté, et à calculer une vitesse d'écoulement critique à partir du taux d'amortissement négatif critique ;
une étape d'entrée dans laquelle on entre une vitesse d'écoulement attendue du fluide ; et
une étape d'évaluation dans laquelle on évalue la vibration auto-excitée du faisceau de tubes (10) pour chaque mode propre par la comparaison de la vitesse d'écoulement attendue du fluide avec la vitesse d'écoulement critique,
dans lequel l'analyse de réponse historique temporelle inclut un calcul qui inclut une simulation de séries chronologiques d'amplitude de vibration qui survient lorsqu'une force d'excitation correspondant au taux d'amortissement négatif est appliquée comme un terme de force externe à un modèle d'analyse de vibration du faisceau de tubes (10), et
dans lequel le modèle d'analyse de vibration détermine une grandeur d'une force de friction entre le faisceau de tubes (10) et l'organe support (7), par la supposition d'une répartition d'une charge de contact agissant entre le faisceau de tubes (10) et l'organe support (7).

2. Procédé d'évaluation de vibration auto-excitée selon la revendication 1, dans lequel l'analyse de réponse historique temporelle inclut :

le calcul d'un taux d'amortissement efficace du faisceau de tubes (10) sur la base d'une relation de décalage entre le taux d'amortissement négatif et un premier taux d'amortissement correspondant à une quantité de dissipation d'énergie de la vibration auto-excitée dissipée conformément à une force de friction entre le faisceau de tubes (10) et l'organe support (7) ; et
la réalisation d'une estimation de séries chronologiques de l'amplitude de vibration du faisceau de tubes (10) sur la base du taux d'amortissement efficace calculé.

**3.** Procédé d'évaluation de vibration auto-excitée selon la revendication 2,
dans lequel l'analyse de réponse historique temporelle inclut :
la détermination que l'amplitude de vibration diverge au moment auquel le taux d'amortissement négatif devient égal au premier taux d'amortissement lorsque l'amplitude de vibration du faisceau de tubes (10) varie.

**4.** Procédé d'évaluation de vibration auto-excitée selon l'une quelconque des revendications 1 à 3,

dans lequel le faisceau de tubes (10) inclut au moins une rangée de tubes (8) formée par une pluralité de tubes en forme de U (3) s'étendant au sein du même plan et partageant un centre de courbure les uns avec les autres, les tubes en forme de U (3) comportant des parties coudées (6) ayant différents rayons de courbure les unes par rapport aux autres,
dans lequel l'organe support inclut au moins une paire de barres anti-vibrations (12) disposées sur les deux côtés de la rangée de tubes (8) de façon à s'étendre le long du plan de part et d'autre de la rangée de tubes (8), et
dans lequel le procédé inclut la détermination de la stabilité d'une vibration hydroélastique dans une direction le long du plan du faisceau de tubes (10) soutenue par une force de friction entre les barres anti-vibrations (12) et le faisceau de tubes (10) contre une force d'excitation du fluide s'écoulant à travers le faisceau de tubes (10).

**5.** Procédé d'évaluation de vibration auto-excitée selon l'une quelconque des revendications 1 à 4,
dans lequel le faisceau de tubes comprend un faisceau (10) de tubes de transfert de chaleur (3) d'un générateur de vapeur d'une centrale nucléaire à réacteur à eau sous pression.

FIG. 1

FIG. 2

FIG. 3

EP 3 451 204 B1

FIG. 4A

FIG. 4B

INPUT PART →

CRITICAL FLOW VELOCITY CALCULATION PART    211

TIME HISTORY RESPONSE ANALYSIS PART    212

SELF-EXCITED VIBRATION EVALUATION PART    213

OUTPUT PART ←

21

EP 3 451 204 B1

FIG. 5

FIG. 6

START

S51 — SET NEGATIVE DAMPING RATIO

S52 — PERFORM TIME HISTORY ANALYSIS

S53 — DETERMINE PRESENCE/ABSENCE OF DIVERGENCE — no

yes

DETERMINE FRICTION DAMPING RATIO

END

## FIG. 7

INPUT PART → EFFECTIVE FLOW VELOCITY CALCULATION PART

NEGATIVE DAMPING RATIO CALCULATION PART

TIME HISTORY RESPONSE ANALYSIS PART

SELF-EXCITED VIBRATION EVALUATION PART → OUTPUT PART

FIG. 8

START

S81 — INPUT PARAMETER
FOR CALCULATING FLOW-VELOCITY

S82 — CALCULATE EFFECTIVE FLOW VELOCITY

S83 — CALCULATE NEGATIVE DAMPING RATIO
CORRESPONDING TO FLOW VELOCITY

S84 — INPUT NEGATIVE DAMPING RATIO AND
PERFORM TIME HISTORY RESPONSE ANALYSIS

S85 — EVALUATE SELF-EXCITED VIBRATION

END

FIG. 9

STABLE REGION

UNSTABLE REGION

K=4.0

K=3.0

CONVERSION FLOW VELOCITY

$\left(\dfrac{U}{fD}\right)$

MASS DAMPING PARAMETER

$\left(\dfrac{2\pi m \zeta}{\rho D^2}\right)$

FIG. 10

CONVERSION FLOW VELOCITY $\left(\dfrac{U}{fD}\right)$

MASS DAMPING PARAMETER $\left(\dfrac{2\pi m\zeta}{\rho D^2}\right)$

EP 3 451 204 B1

**EP 3 451 204 B1**

**Patent documents cited in the description**

- JP 2014109906 A
- JP 2014134957 A
- JP 2015026259 A

**Non-patent literature cited in the description**

- **SHAHAB KHUSHNOOD et al.** *A review of heat exchanger tuber bundle vibrations in two-phase cross-flow*
- **XIN XIN et al.** *Optimal control design of self-excited vibration systems*